# EUROPEAN PATENT SPECIFICATION

(11) **EP 1 420 512 B1**
(45) Date of publication and mention of the grant of the patent: **21.01.2009**
(21) Application number: 03026076.4
(22) Date of filing: 12.11.2003
(51) Int. Cl.: H03D 13/00, G01R 25/04

(54) **Phase detector with delay elements for improved data regeneration**
Phasendetektor mit Verzögerungselementen für verbesserte Datenregeneration
Détecteur de phase avec éléments de retard pour regénération de données amelioree

(30) Priority: 12.11.2002 US 293624
(43) Date of publication of application: 19.05.2004
(73) Proprietor: Broadcom Corporation, Irvine, CA 92617 (US)
(72) Inventor: Cao, Jun, Irvine California 92620 (US); Momtaz, Afshin, Irvine California 92612 (US)
(74) Representative: Jehle, Volker Armin

(56) References cited:
- US-A1- 2001 033 407
- US-B1- 6 316 966
- HOGGE C R: "A SELF CORRECTING CLOCK RECOVERY CIRCUIT" JOURNAL OF LIGHTWAVE TECHNOLOGY, IEEE. NEW YORK, US, vol. LT-3, no. 6, 1 December 1985 (1985-12-01), pages 1312-1314, XP000560659 ISSN: 0733-8724

## Description

### CROSS-REFERENCES TO RELATED APPLICATIONS

This application is related to commonly assigned, copending United States patent application number 10/293,624 filed 12.11.2002, titled Phase Detector for Extended Linear Response and High-Speed Date Regeneration, by Cao, published on 13.05.2004 under No. US-2004-0091064 A1.

### BACKGROUND

The present invention relates generally to phase detectors, and more specifically to phase detectors having delay elements for improved data regeneration.

Data networking has exploded over the last several years and has changed the way people work, get information, and spend leisure time. Local area networks at the office allow for centralized file sharing and archiving. Mobile phones allow users access to news updates and stock quotes. The Internet has transformed shopping and has spawned a new recreational activity―web surfing. Many computers are used primarily as interfaces to these networks; thus the expression "the network is the computer" has been coined.

Devices such as network interface cards (NICs), bridges, routers, switches, and hubs move data between users, between users and servers, or between servers. Data moves over a variety of media such as fiber optic or twisted pair cables and the air. These media distort data, making it difficult to be read. Lightwaves traveling in a fiber optic cable reflect at the core-cladding interface and disperse. Twisted pair cables filter higher frequencies. Wireless signals bounce off surfaces in a phenomenon known as multipath, smudging one data bit into the next.

Accordingly, these devices, NICs, bridges, routers, switches, and hubs, receive distorted data and clean it up - or retime it - for use either by the device itself or for retransmission. A useful building block for this is the clock and data recovery (CDR) circuit. CDRs accept distorted data and provide a clock signal and retimed (or recovered) data as outputs.

A clock and data recovery circuit clock signal is typically used to extract a clock signal and recover data from an incoming data stream. The clock is recovered by a phase detector and voltage controlled oscillator (VCO). A clock signal at a frequency, matching that of an incoming data stream is generated by the VCO. Active edges of this clock signal are aligned to an averaged center of the data stream by the phase detector, a process referred to as window centering. The clock is then used by a data regeneration circuit to sample the data stream to recover individual data bits. But a separate data regeneration circuit consumes die area and increases chip power dissipation. Accordingly, what is needed are circuits and methods for combining the data regeneration circuits into the phase detector. It is also desirable to be able to independently adjust the timing of the data regeneration circuit to improve data recovery.

US2001033407 discloses a method and apparatus for recovering a clock and data from a data signal by receiving the data signal having a first data rate and receiving a clock signal having a first clock frequency, and alternating between a first level and a second level. The data signal is stored when the clock signal alternates from the first level to the second level, and the stored data signal is provided as a first signal a first amount of time later. A third signal is provided by delaying the first signal for a third amount of time. The third signal is stored when the clock signal alternates from the second level to the first level, and the stored third signal is provided as a fourth signal a fourth amount of time later. A fifth signal is provided by delaying the data signal a fifth amount of time. An error signal is generated by taking the exclusive-0R of the first and fifth signals; and a reference signal is generated by taking the exclusive-OR of the second and fourth signals.

US6316966 is directed to fiber optic networks transferring data using encoding in which the clock is transmitted along with the data, for example in NRZ format. To compensate for the changing offset, one or more variable delays are inserted in the phase detector circuitry. The timing of the variable delay is controlled by a bang-bang phase detector, which determines if the clock is leading, lagging, or in phase with the data. The delay control loops integrate the output of the bang-bang phase detector and use the output to control a decimated up down counter, which is then further used to control one or more variable delays. The counter can be pre-loaded with a default start point, and the bandwidth of the loops can be dynamically adjusted by changing the decimation ratio and sample periods of the loop.

HOGGE C R: "A SELF CORRECTING CLOCK RECOVERY CIRCUIT" JOURNAL OF LIGHTWAVE TECHNOLOGY, IEEE. NEW YORK, US, vol. LT-3, no. 6, 1 December 1985 (1985-12-01), pages 1312-1314, XP000560659 ISSN: 0733-8724 describes an approach to extract clock from NRZ data, wherein balanced inputs are provided to a loop filter midway between logic levels regardless of the data transition.

### SUMMARY

Accordingly, embodiments of the present invention provide circuits and methods for simplifying clock an data recovery circuits by incorporating a data regeneration circuit as part of a phase detector circuit. Delay elements are added such that the timing of the data recovery is optimized or improved with little or no effect on the clock recovery operation. This allows die area and power supply savings, while retaining the flexibility of independently adjusting data recovery timing.

An exemplary embodiment of the present invention provides a method of recovering data from a data signal. The method includes receiving a clock signal having a first clock frequency, and alternating between a first level and a second level, receiving the data signal having a first data rate, the first data rate being substantially equal to the first clock frequency, providing a first signal by delaying the data signal a first duration, providing a second signal by delaying the data signal a second duration, providing a third signal by storing the second signal when the clock signal alternates from the first level to the second level, and providing a fourth signal by storing the third signal when the clock signal alternates from the second level to the first level. The method also includes providing an error signal by combining the first signal and the third signal, and providing a reference signal by combining the second signal and the third signal.

A further exemplary embodiment of the present invention provides a phase detector for recovering data from a data signal. The phase detector includes a first delay element configured to delay the data signal a first duration, a second delay element configured to delay the data signal a second duration, and a first storage device configured to receive and store an output of the second delay element. Also included are a first logic circuit configured to receive an output of the first delay element and provide an error signal, and a second logic circuit configured to receive an output of the first storage device and provide a reference signal.

Yet a further exemplary embodiment of the present invention provides a phase detector for recovering data from a received data signal. This phase detector includes a first delay circuit coupled to an input port, a second delay circuit coupled to the input port, and a flip-flop having a input coupled to an output of the second delay element and a clock input coupled to a clock port. The phase detector also includes a first logic circuit having a first input coupled to an output of the first delay element and a second logic circuit having a first input coupled to an output of the flip-flop.

A better understanding of the nature and advantages of the present invention may be gained with reference to the following detailed description and the accompanying drawings.

### BRIEF DESCRIPTION OF THE DRAWINGS

Figure 1 is a block diagram of an exemplary optical transceiver that may incorporate an embodiment of the present invention;
Figure 2 is a block diagram of a clock and data recovery circuit in accordance with an embodiment of the present invention;
Figure 3 is a plot illustrating the ERROR and REFERENCE signals as functions of a phase difference between a data signal and VCO clock signal for a phase detector consistent with an embodiment of the present invention;
Figure 4 is a block diagram of a phase detector consistent with an embodiment of the present invention;
Figure 5 is a generalized timing diagram of signals in a phase detector consistent with an embodiment of the present invention;
Figure 6 is a timing diagram of an embodiment of the present invention showing two specific data transitions;
Figure 7 is a generalized timing diagram of signals in a phase detector consistent with an embodiment of the present invention where the delay of one delay element is increased;
Figure 8 shows the timing of Figure 7 for two specific data transitions;
Figure 9 is another block diagram of a phase detector consistent with an embodiment of the present invention;
Figure 10 is a generalized timing diagram of signals in a phase detector consistent with one embodiment of the present invention;
Figure 11 shows the timing of Figure 10 for two specific data transitions;
Figure 12 is a schematic for an exemplary implementation of a negative-edge triggered flip-flop that may be used as one or more of the flip-flops in Figures 4 and 9;
Figure 13 is a schematic of a latch that may be used as one or more of the latches in Figure 9;
Figure 14 and is an exemplary high speed XOR gate that may be used as one or more of the XOR gates in Figures 4 and 9; and
Figure 15 is a schematic of an exemplary circuit implementation for a delay element that may be used as one or more of the delay elements in Figures 4 and 9.

### DESCRIPTION OF EXEMPLARY EMBODIMENTS

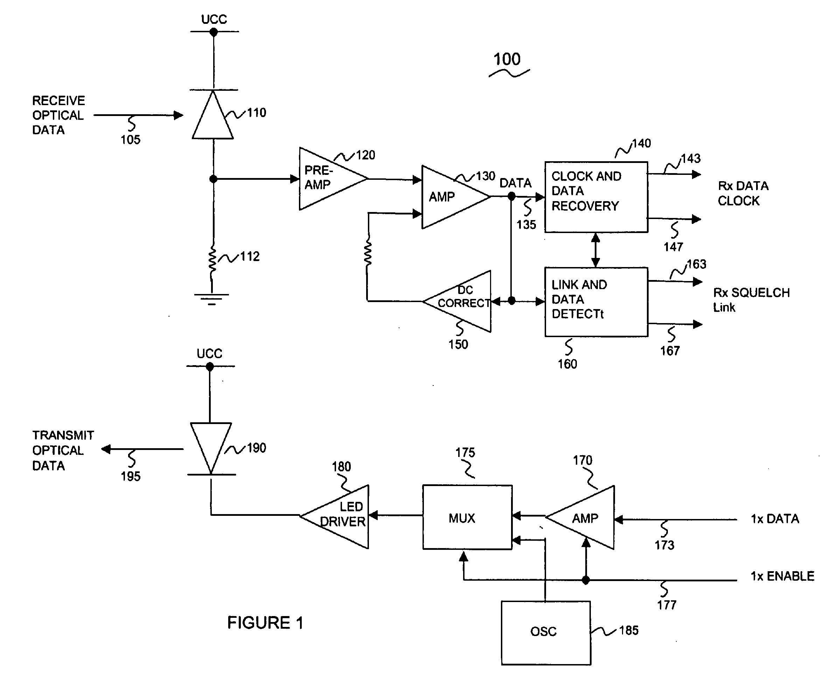

Figure 1 is an exemplary block diagram of an optical transceiver that may benefit by incorporating an embodiment of the present invention. This figure, as with all the included figures, is shown for illustrative purposes only and does not limit either the possible applications of the present invention or the appended claims. This optical transceiver may be on a NIC with a media access controller, some memory, and other circuits, or it may be in a hub, router, switch, or other piece of equipment.

Shown is a receive path including a photo diode 110, sensing resistor 112, pre-amplifier 120, amplifier 130, DC offset correction circuit 150, clock and data recovery circuit 140, and link and data detect 160. A transmit path includes an amplifier 170, light emitting diode (LED) driver 180, multiplexer 175, oscillator 185, and LED 190. Instead of the LED driver 180 and LED 190, the optical transmitting subsystem may alternately include a laser driver and laser diode.

A receive fiber optic cable 105 carries an optical data signal to the reversed-biased photo diode 110. Photo diode 110 senses the amount of light from fiber optic cable 105 and a proportional leakage current flows from the device's cathode to anode. This current flows though sense resistor 112, and generates a voltage. This voltage is amplified by pre-amplifier 120 and amplifier 130. Offsets are reduced by DC correction circuit 150. The output of amplifier 130 drives the clock and data recovery circuit 140, as well as the link and data detect block 160. The clock and data recovery circuits extract the clock signal embedded in the data provided on line 135 by the amplifier and with it retimes the data for output on lines 143. If the link and data detect block 160 senses either a data or link signal at the data line 135, a valid link signal is asserted on line 167. When the link and data detect block 160 senses a data signal at the data line 135, a receive squelch signal is de-asserted on line 163.

Transmit data is provided on line 173 to amplifier 170. Amplifier 170 is enabled or disabled by the transmit enable signal on line 177. When amplifier 170 is enabled, transmit data is passed to the multiplexer 175. Multiplexer 175 passes the transmit data to the LED driver 180, which in turn generates a current through LED 190. When current is driven through LED 190, light is emitted and transmitted on fiber optic cable 195. When the LED driver 180 is not driving current though LED 190, the LED is off, and the fiber optic cable 195 is dark. If the amplifier 170 is disabled, multiplexer 175 selects the idle signal from oscillator block 185. Oscillator block 185 provides an idle signal through the multiplexer 175 to the LED driver 180. This idle signal is used by a remote receiver to ensure that a valid optical connection has been made at both ends of the fiber-optic cable 105.

Again, the fiber optic media's physical limitations distort the received signal. Moreover, the delay through the amplifier 170, multiplexer 175, LED driver 180, and LED 190 may not be the same for light-to-dark and dark-to-light transitions. This mismatch causes duty cycle distortion. Further, transistor thermal noise and electrical noise in the power supply and data path generate jitter and phase noise, thus the delay through the transmitter changes as a function of time. Clock and data recovery circuits, such as block 140, retime data so it is in a more useable form for further processing, and provide a clock synchronized to the retimed data.

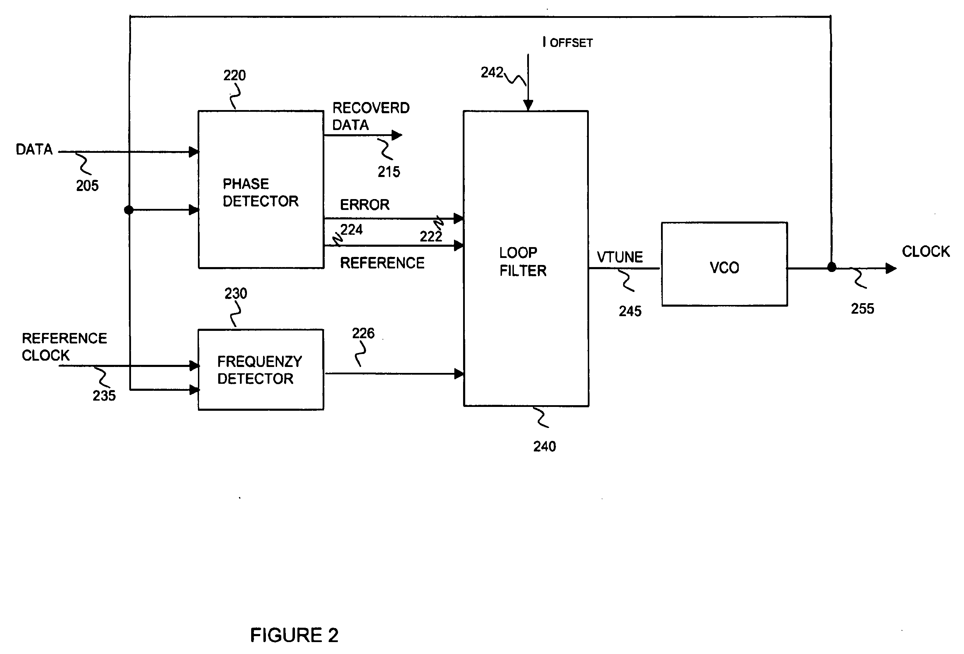

Figure 2 is a simplified block diagram of a clock and data recovery circuit or phase-locked loop consistent with an embodiment of the present invention. This architecture is shown for exemplary purposes, and does not limit either the possible applications of the present invention or the appended claims.

Included are a phase detector 220, frequency detector 230, loop filter 240, and VCO 250. Other architectures will be readily apparent to those skilled in the art. For example, phase detector 220 and frequency detector 230 may be the same circuit, possibly under the control of a mode switch.

At startup, the loop adjusts the VCO 250 frequency. Startup may be initiated by the power supply turning on, by the reception of a valid link by the receiver, or other appropriate event. A reference clock is provided on lines 235 to the frequency detector 230. The reference clock is often a comparatively low-frequency signal generated by a stable oscillation source, for example a crystal. The output of the VCO 250, the CLOCK signal on lines 255, is typically divided down by an integral value and compared to the reference clock by the frequency detector 230. Frequency detector 230 provides an output signal on line 226 that is filtered by loop filter 240 and provided to VCO 250 as tuning voltage VTUNE 245. If the frequency of the CLOCK signal on lines 255 is too high, the frequency detector 230 changes its output voltage on line 226, and thus VTUNE on line 245, in such a direction as to lower the CLOCK signal's frequency. Conversely, if the CLOCK signal on lines 255 is too low in frequency, the frequency detector 230 changes its output voltage on line 226, and thus VTUNE on lined 245, in such a direction as to raise the CLOCK signal's frequency.

Once the CLOCK signal on lines 255 is tuned to approximately the correct frequency, the phase detector 220 becomes active, and the frequency detector 230 becomes inactive. It may be determined that the clock signal is at approximately the correct frequency by monitoring Vtune, by the passage of a predetermined amount of time, by another event or combination of these events. A DATA signal on line 205 is received by the phase detector 220 on lines 205. Phase detector 220 compares the centers of data bits in the DATA signal on lines 205 to the falling edges of the CLOCK signal on lines 255, and produces an ERROR signal on line 222 that is proportional to the phase relationship between them. Alternately, the phase detector 220 can be designed so that the centers of the data bits in the DATA signal are compared to the rising edges of the CLOCK signal. Phase detector 220 also produces a REFERENCE signal on line 224 that can be subtracted from the ERROR signal to generate a data pattern independent correction signal. The ERROR and REFERENCE signals are subtracted and filtered by the loop filter 240 resulting in a voltage VTUNE 245. The phase detector 220 also provides a recovered data signal on line 215. Each of the signals shown may be single-ended or differential signals.

As its name implies, the voltage controlled oscillator is an oscillator, the frequency of which is controlled by a voltage, in this example VTUNE. As VTUNE changes, the oscillation frequency changes. If the DATA signal on lines 205 and the CLOCK signal on lines 255 do not have the desired phase relationship, the error voltage, and thus VTUNE, changes in the direction necessary to adjust the VCO in order to correct the phase error. In a specific embodiment, if the DATA signal on lines 205 comes too soon, that is, it is advanced in time relative to the CLOCK signal on lines 255, the phase detector increases the ERROR voltage on line 222. This results in a change in the VTUNE voltage 245 that increases the frequency of the CLOCK 255. As the frequency of the CLOCK signal on lines 255 increases, its edges come sooner in time, that is they advance. This in turn, brings the clock's falling edges into alignment with centers of the data bits in the data signal on lines 205. As the edges move into alignment, the error signal on line 222 reduces, changing VTUNE 245, thereby reducing the frequency of the CLOCK signal on lines 255. This feedback insurers that the DATA and CLOCK signals have the proper phase relationship for retiming the data by retiming block 210. In this condition the loop is said to be locked. Hence, clock and data recovery circuits are alternately referred to as phase-locked loops.

The ERROR signal on line 222 and the REFERENCE signal on line 224 provide a relatively low frequency, essentially differential, correction signal. This has several important benefits. For example, the use of a REFERENCE signal gives context to the ERROR signal, reducing the data dependent phase errors which would otherwise result. If there are no data transitions this loop has no ERROR or REFERENCE signal information to lock to, but since there is no data to recover, this special case is of no interest.

Also, conventional systems often employ what is known as a "bang-bang" phase detector. In bang-bang detectors, for each data edge, depending on its relation to the clock, a charge-up or charge-down signal is sent to a charge pump. Such detectors alternate between advancing and delaying the clock signal from the VCO but never reach a stable point. Accordingly, bang-bang detectors have a certain amount of systematic jitter. Moreover, these pulses have fast edges containing high frequency components that couple to the supply voltage and inject noise into other circuits. Reducing this noise requires either filtering or using separate supply lines decoupled from each other. By using a low frequency, effectively differential signal out, the linear full-rate phase detector of the present invention does not have this systematic jitter and does not disturb the power supply and other circuits to the same extent.

When the CDR is locked, the net charging current the loop filter is zero, and typically, the data is centered on the active edges of the clock signal from the VCO. An offset current Ioffset on line 242 may be applied to the loop filter while the phase-locked loop is tracking data on the data line 205. For the loop filter net charging current to remain zero, the offset current is cancelled by a non-zero input from the phase detector resulting from a phase offset between the incoming data and clock signals. Accordingly, phase relationship between the DATA signal on line 205 and the CLOCK signal on line 255 may be adjusted by varying the magnitude and polarity of the offset current Ioffset 242.

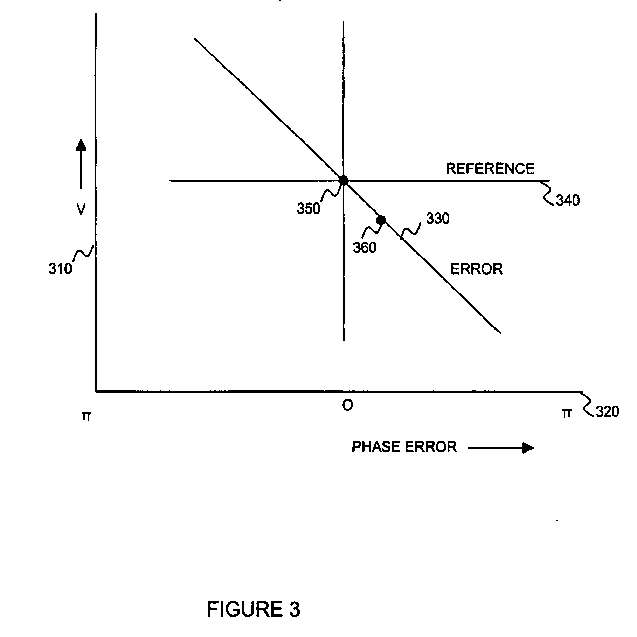

Figure 3 is a plot illustrating the ERROR and REFERENCE signals for a phase detector consistent with an embodiment of the present invention. The ERROR and REFERENCE signal voltages, the gain of the phase detector, are plotted as curves 330 and 340 along a Y-axis 310 of voltage as a function of phase error between the received data and clock signal from the VCO on X-axis 320.

A portion of the operating curves is shown. These curves may have inflection points near the ends of the operating range. These points are not shown for clarity, and their location and the exact shape of the curve depend on the exact circuit implementation used. Beyond these points, the phase detector no longer provides an output signal that properly tracks the input data signal phase error. Typically, when the loop is a locked, the phase detector operates at or near a zero phase error at point 350, that is where the REFERENCE and ERROR signals are matched. Again, an offset current may be applied to the charge pump or loop filter in the phase locked loop, thus shifting the operating point from a zero phase error, for example to point 360. The static phase difference may be shifted to center circuit operation if the linear or monotonic range of the gain curve is not symmetrical. For example, this may help widen the capture range of the circuit at start-up.

The REFERENCE signal 340 is data dependent, while the ERROR signal is both data and phase dependent. As can be seen, the ERROR signal provides a signal that is proportional (or inversely proportional) to the phase error between the incoming data and VCO clock signals.

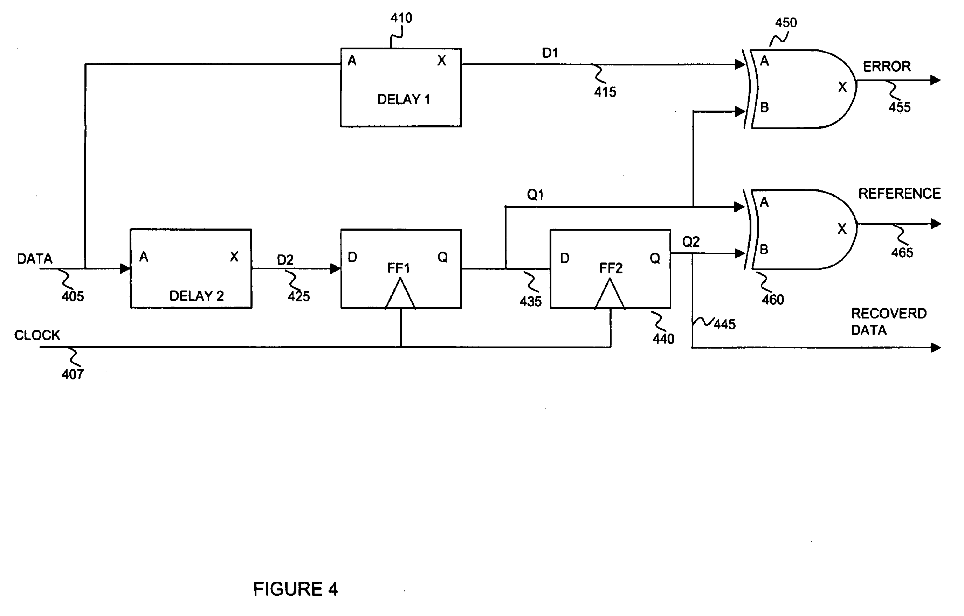

Figure 4 is a block diagram of a phase detector consistent with an embodiment of the present invention. This phase detector may be used as the phase detector 220 in Figure 2. Alternately, it may be used as the phase detector in other CDR architectures. For example, it may be used in an architecture having a charge pump between the phase detector and loop filter. The phase detector shown may be used in a CDR in a fiber optic transceiver, as shown in Figure 1. Alternately, it may be used in a CDR in other systems. Phase locked-loops are particularly important where a data processing system interfaces with a physical medium. Accordingly, this phase detector, and other phase detectors consistent with an embodiment of the present invention may be used in CDRs in twisted pair or coaxial transceivers, disk-drive or other mass-storage read channels, wireless receivers, routers, NICs, bridges, switches, hubs, and other electronic devices, circuits, and systems.

Included are a first delay element 410, second delay element 420, first flip-flop 430, second flip-flop 440, and exclusive-OR (XOR) gates 450 and 460. In a specific embodiment, the flip-flops 430 and 440 are a negative-edge triggered devices. That is, flip-flop 430 changes state on falling edges of the clock signal, and since its clock input is inverted, flip-flop 440 changes state on rising edges of the clock. With this configuration, the phase detector aligns the data centers to clock falling edges. If no offset current Ioffset 242 is applied, the falling edges of the clock are centered in the (averaged) middle of the incoming data bits. This "window centering" ensures that as the data eye closes due to noise, jitter, and the like, data recovery remains optimum, given a symmetrical distortion pattern. In other embodiments, a positive-edge triggered flip-flops may be used. In this alternate configuration, the phase detector aligns the centers of the data bits to the clock rising edges. Again, in either configuration, if an offset current Ioffset 242, or similar current is applied to the loop feature or charge pump, the clock edges shift relative to the center of the average data bit.

All signal paths shown may be differential or single-ended. For example, Q1 435 may be a differential signal including flip-flop 430 output signals Q and its complement, QBAR. In a specific embodiment, all signal paths are differential. Using differential signals reduces the jitter caused by noise from such sources as the power supply and bias lines.

Modifications to this block diagram will be readily apparent to one skilled in the art. For example, a combination of AND and OR gates may replace the XOR gates, or two latches may replace each of the flip-flops, resulting in a four latch configuration.

DATA on line 405 is received by the first and second delay elements 410 and 420. The output of the second delay element 420 drives the D input of the first flip-flop 430. The flip-flop 430 is clocked by the CLOCK signal on lines 407 from a VCO or other clock or periodic source. On each CLOCK falling edge, the D2 signal on lines 425 is latched by the flip-flop 430 and held at the Q output as signal Q1 on line 435. The signal Q1 on lines 435 is stored by the second flip-flop 440 on rising edges of the clock signal on lines 407. The second flip-flop 440 provides an output signal Q2 on line 445. Either the output signal Q1 on lines 435 or Q2 on lines 445 can be used as the recovered data signal.

Delay element 410 delays the data signal and provides an output D1 on line 415. In a specific embodiment, the delay through the first delay element 410 approximately equals the clock-to-Q delay of the first flip-flop 430. As seen below, this delay may alternately be less than or greater than the clock-to-Q delay of the first flip-flop 430. The clock-to-Q delay for a flip-flop is the delay of the output changing in response to a clock edge. XOR gate 450 receives Q1 on line 435 and D1 on line 415 as inputs. The output of XOR gate 450 is the ERROR signal on line 455. XOR gate 460 has Q1 on line 435 and Q2 on line 445 as inputs. The output of XOR gate 460 is the REFERENCE signal on line 465.

The delays thought the first and second delay elements 410 and 420 can either be fixed or variable. Values for the delays may be determined by simulation, and the delay elements may be designed accordingly. They may be controlled at least partly by some number of capacitors or resistors, the number of which may be varied by later changes to one or more of the metal or other conductive layers. The delays may also be varied by other mechanisms, such as trim pads, laser trimming, fuses, and the like. They may also be programmably controlled. The two delays may be implemented in the same or similar manner, or they may be implemented in different manners.

As can be seen, the recovered data is provided on line 445 without the requirement of an additional data regeneration circuit. This saves not only die area if this circuit is integrated, but reduces power supply current as well. Also, the insertion of the second delay 420 allows centering of the data recovery timing, but does not significantly disrupt the clock recovery function of this circuit. Moreover, if the static phase operating point is shifted, for example by the addition of an offset current Ioffset 242, the data recovery timing of this circuit can be corrected by properly adjusting the delay of the second delay element.

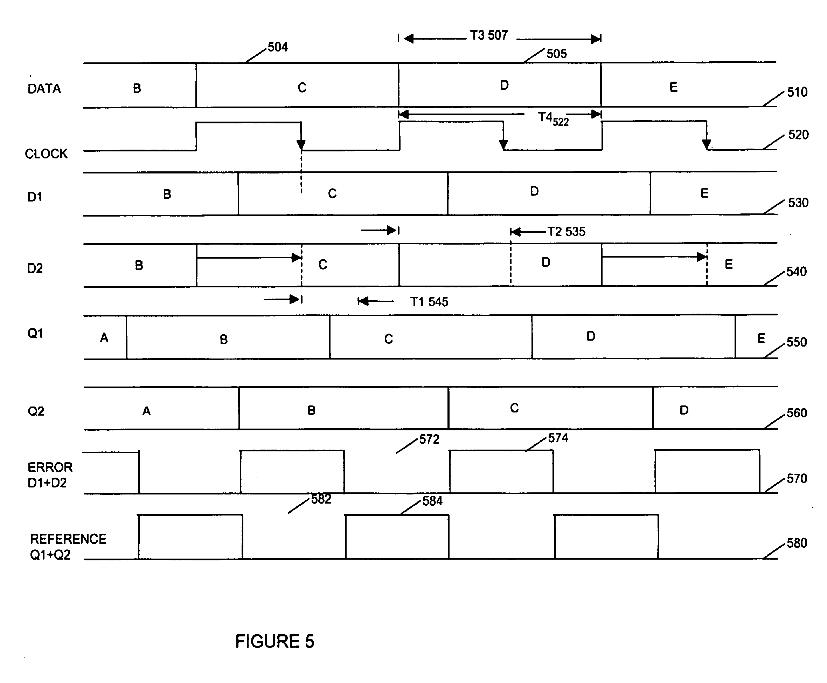

Figure 5 is a general timing diagram showing signals in a phase detector consistent with one embodiment of the present invention, such as the block diagram of Figure 4. This and the following timing diagrams are not limited to the circuit of Figure 4 and may be generated by other circuitry consistent with the present invention. Included are inputs DATA 510 and CLOCK 520, and resulting signals D1 530, D2 540, Q1 550, Q2 560, ERROR 570, and REFERENCE 580. Data bits, such as 504 and 505, have a duration approximately equal to one clock cycle. Each data bit may be high or low, and the DATA signal 510 may transition or remain constant from one bit to the next.

Q1 540 is DATA 510 retimed. There is typically a delay between a transition of Q1 540 as compared to the falling edges of the CLOCK 520, particularly if Q1 is generated by a flip-flop clocked by falling edges of the CLOCK signal 520 and having DATA 510 as its D input. The delay is shown here as t₁ 545. Q2 560 is Q1 550 delayed by one half clock cycle. There may be a delay between a transition of Q2 560 as compared to the rising edges of the CLOCK 520, particularly if Q2 is generated by a flip-flop.

Signals D1 530 and D2 540 are delayed versions of DATA 510. In this example, D1 530 is generated by delaying DATA 510 by an amount approximately equal to the delay of signal Q1 540 as compared to the CLOCK 520.

The delay of D2 can range from zero to an amount such that transitions in D2 are near the falling edges of the CLOCK 520. D2 transitions can approach the falling edges of the CLOCK 520 to the point where the setup time of the flip-flop or other storage circuit or circuits that generate Q1 is on the verge of not being met. Also, approximately at this point, the clock-to-Q of that flip-flop or other circuits begins to increase and the phase detector gain may become non-monotonic. The range of values of D2 is shown as t₂ 535.

The delays used to generate D1 and D2 can be either fixed or variable. Values may be determined by simulation, and the delay elements may be designed accordingly. They may be controlled at least partly by some number of capacitors or resistors, the number of which may be varied by later changes to one or more of the metal or other conductive layers. The delays may also be varied by other mechanisms, such as trim pads, laser trimming, fuses, and the like. They may also be programmably controlled. The two delays may be implemented in the same or similar manner, or they may be implemented in different manners.

D2 may vary over the range 535 without significantly effecting the clock recovery of this circuit, again, so long as the setup time of the circuit that generates Q1 is met and its clock-to-Q does not become excessive. This means that the setup and hold time of that circuit, for example, the first flip-flop 440 in Figure 4, may be adjusted for improved data regeneration. Moreover, if the static input phase error between the CLOCK and DATA are offset, for example by offset current Ioffset 242, the setup time for the first flip-flop may not be optimal. By adjusting the second delay D2, the setup time may be changed to improve data recovery, thus compensating for the static phase difference. This means input static phase difference between the DATA and CLOCK is independently adjustable from the setup time of the first flip-flop. Thus, clock recovery, which may be optimized or improved by offsetting the input phase error, is independent of data recovery, which may be optimized or improved by adjusting the setup time of the first flip-flop.

As can be seen, changes in D2 540 do not cause changes in D1 530, Q1 550, or Q3 560, the signals that are used to generate the ERROR and REFERENCE signals 570 and 580, so long as the above criteria are met. Specifically, the ERROR signal 570 is generated by XORing D1 530 and Q1 550. REFERENCE 580 is generated by XORing Q1 550 and Q2 560. For reasons of clarity, in this and the following figures, the delay through the XOR gates is zero.

When transitions of the DATA signal 510 are approximately centered between clock falling edges, for some time period approximately following each fallinege of CLOCK 520, ERROR 570 is low. This is because after each falling edge of CLOCK 520, Q1 550 follows DATA 510. Accordingly, for some time period following each clock falling edge, Q1 550 and D1 530 are equal in value. For example, in the time 572 prior to the ERROR pulse 574, both D1 530 and Q1 550 are in the state C. Sometime later, DATA 510 either transitions to a new level or retains the same value. If DATA 510 changes to a new state, then D1 530 and Q1 550 become unequal, and the ERROR signal 570 is high at 574. But if data signal 510 retains its value, ERROR 570 remains low at 574. Specifically, if data bits C and D are equal, then ERROR bit 574 is low. But if data bits C and D are not equal, then ERROR bit 574 is high.

ERROR signal 570 is dependent on the phase relationship between DATA 510 and CLOCK 520 in the following manner. If data bit 504 - C - is low and data bit 505 - D - is high, then ERROR pulse 574 is high. If the DATA signal 510 advances, that is shifted to the left, then pulse 574 widens (becomes longer in duration). If the DATA signal 510 is delayed, that is shifted to the right, then pulse 574 narrows (becomes shorter in duration).

But note as above, if C and D are equal, then ERROR pulse 574 is low. Therefore, the average ERROR voltage is dependent not only on the phase error between CLOCK 520 and DATA 510, but on the data pattern of DATA 510. For this reason, the ERROR signal 570 is most meaningful in the context of REFERENCE signal 580.

This is because the REFERENCE signal's average value is also data dependent. For some time period following each falling edge of CLOCK signal 520, the REFERENCE signal 580 is low, since at each rising edge of the CLOCK 520, Q1 550 is equal to Q2 560. For example, in the time prior 582 before reference pulse 584, both Q1 550 and Q2 560 have the value B. In the next half CLOCK cycle Q1 550 has the value of the next data bit C while Q2 560 remains unchanged. Therefore, if the data bits B and C are equal then REFERENCE pulse 584 is low. But if data bits C and D are not equal, then REFERENCE bit 584 is high.

For random data, each data bit may be high or low with equal probability and may change state or remain constant at each transition, also with equal probability. Thus, each ERROR pulse, such as 574, has an equal probability of being high or low. Also each REFERENCE signal pulse, such as 584, is high an equal number of times as the ERROR probes. If the center DATA bits are aligned with the falling edge of the CLOCK 520, the ERROR signal 570 and the REFERENCE signal 580 are each low half the time and either high or low with equal probability the other half. This means that the ERROR signal 570 and REFERENCE signal 580 each have an average AC value equal to one-fourth their AC peak value.

If the data is not random, for instance if DATA 510 consists of a long string of either high or low data bits, then error pulses, such as 574, and REFERENCE pulses, such as 584 are low. The error and reference signals' average values are at a minimum. But if the data changes every bit, then each error signal pulse and each reference bit is high. Therefore, the error and reference signals are equal to one-half their peak values. Thus, the error and reference signals have the same data pattern dependency, while the error signal also tracks the phase error. This means the data dependency of ERROR signal 570 can be corrected by subtracting the REFERENCE signal 580. The difference signal between error and reference is not dependent on the data pattern, but is dependent on the phase error. This resulting signal has approximately a zero value when the edges of the data signal are aligned with the clock rising edges. As the data is delayed, the differential value becomes negative. As the data advances, the difference becomes positive.

Each data bit has a duration approximately equal to t₃ 507. The reciprocal of the data bit duration t₃ 507 is referred to as the data rate. Each clock period has a duration t₄ 522, where t₄ is approximately equal to t₃ when the loop is in a locked state. The clock frequency is the reciprocal of the duration t₄ 522. Thus, the clock frequency is approximately equal to the data rate.

Various modifications will be apparent to one skilled in the art. For example, a clock signal with a reversed polarity may be used, such that the centers data bits align with the clock rising edges.

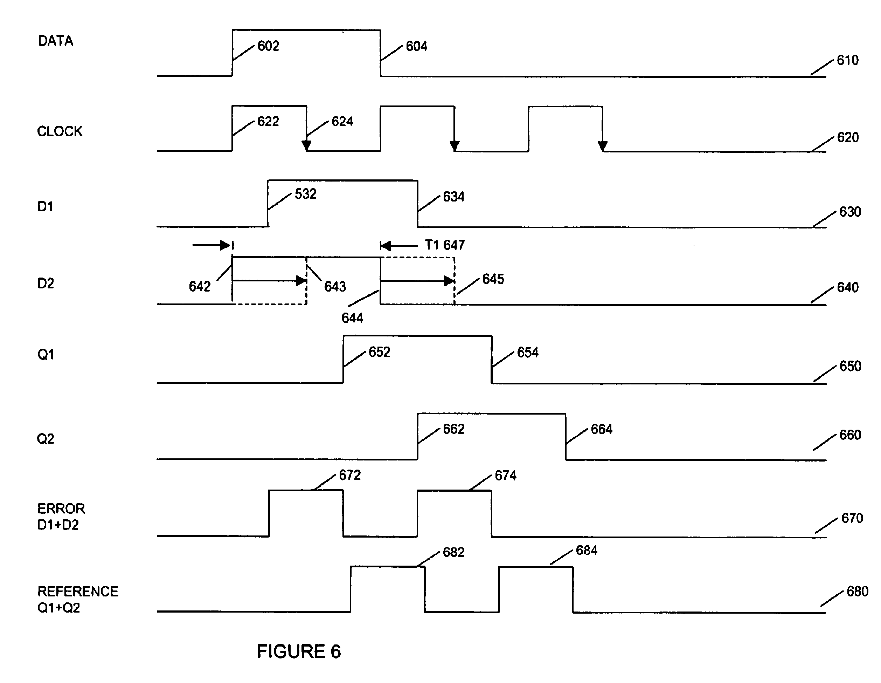

Figure 6 is a timing diagram of an embodiment of the present invention for two specific data transitions 602 and 604. Included are inputs DATA 610 and CLOCK 620, and resulting signals D1 630, D2, 640, Q1 650, Q2 660, ERROR 670, and REFERENCE 680. Q1 650 is DATA signal 610 retimed and following the next falling edge of CLOCK 620. Q2 660 is Q1 640 delayed by one half a clock cycle. D1 630 and D2 640 are DATA 610 delayed in time. Again, DATA 610 may be delayed by a time approximately equal to the phase delay between a transition in Q1 650 and a falling edge of CLOCK 620 to generate D1 630. Alternately, the delay may be greater than or less than this duration. ERROR 670 is the XOR of D1 630 and Q1 650. REFERENCE 680 is the XOR between Q1 650 and Q2 660.

As can be seen in this diagram, an ERROR pulse 672 and a REFERENCE pulse 682 result from the data transmission 602. Specifically, ERROR pulse 672 begins, or goes high, at the rising edge 632 of D1 630 and returns low at the rising edge 642 of Q1 640. Similarly, REFERENCE pulse 682 begins at the edge 652 of Q2 650 and ends when Q3 660 goes high at edge 662.

Again, the delay D2 may range from zero to such a value that transition edge 643 is near the falling edge 624 of the CLOCK 620. Around this point, depending on exact circuit implementation, the setup time for the circuit or circuits that generate Q1 650, for example the first flip-flop 440 in Figure 4, is not met. Also around this point, the clock-to-Q for this circuit or circuits begins to increase, resutling in non-monotonic gain characteristics for the phase detector. This range of values for D2 is shown as t₁ 645. So long as D2 is short enough that the clock-to-Q delay does not begin to dramatically increase, the setup time for the first flip-flop may be adjusted, thus improving the data recovery, without significantly effecting the clock recovery operation of the circuit.

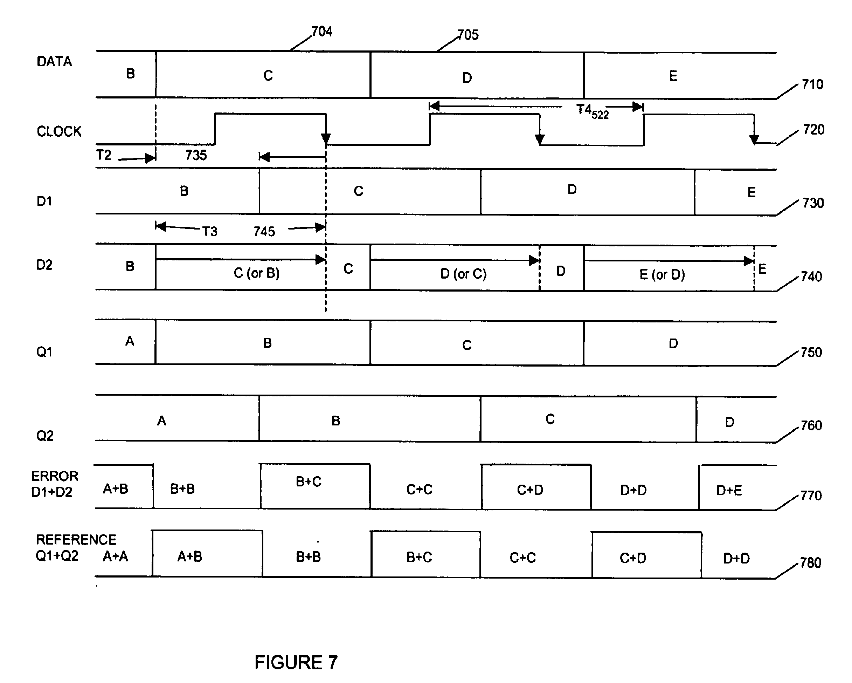

Figure 7 is a general timing diagram of signals in a phase detector consistent with one embodiment of the present invention, such as the block diagram of Figure 4, where the delay of the first delay element 410 is set to be greater than the clock-to-Q delay of the first flip-flop 430. This timing diagram is not limited to the circuit of Figure 4 and may be generated by other circuitry consistent with the present invention. Included are inputs DATA 710 and CLOCK 720, and resulting signals D1 730, D2, 740, Q1 750, Q2 760, ERROR 770, and REFERENCE 780. Data bits, such as 704 and 705, have a duration approximately equal to one clock cycle. Each data bit may be high or low, and the DATA signal 710 may transition or remain constant from one bit to the next.

Q 1 750 is DATA 710 retimed. There is typically a delay between a transition of Q1 750 as compared to the falling edges of the CLOCK 720, particularly if Q1 is generated by a flip-flop clocked by falling edges of the CLOCK signal 720 and having DATA 710 as its D input. This delay is shown as t₁ 755. Q2 760 is Q1 750 delayed by one half clock cycle. There may be a delay between transitions of Q2 760 as compared to the edges of CLOCK 720. Signals D1 730 and D2 740 are delayed versions of DATA 710.

D1 730 may be generated by delaying DATA 710 by an amount that is greater than the delay of signal Q1 750 as compared to the CLOCK 720. This delay is shown as t₂ 735. The result of making the delay D1 greater than the clock-to-Q of the circuit or circuits that generate Q1 750 is that the adjustment range of D2 740 is increased. This increased range is shown as t₃ 745. The increase in range is approximately equal to the delay through D1 less the clock-to-Q delay of the first flip-flop 430 or other circuit used to generate Q1 750.

ERROR 770 is generated by XORing D1 730 and Q1 750. REFERENCE 780 is generated by XORing Q1 750 and Q2 760.

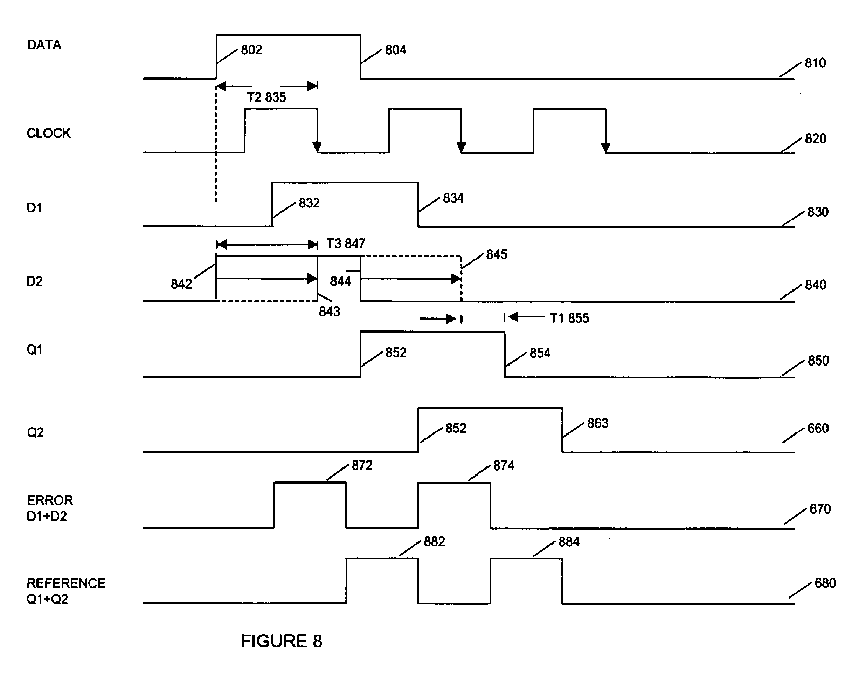

Figure 8 shows this for specific DATA transitions 802 and 804. Shown is a timing diagram with a clock-to-Q delay t₁ 855 that is exceeded by a D1 delay, specifically t₂ 835. Included are inputs DATA 810 and CLOCK 820, and resulting signals D1 830, D2 840, Q1 850, Q2 860, ERROR 870, and REFERENCE 880. Transition 802 in DATA 810 results in a pulse in ERROR waveform 870, specifically 872, and a REFERENCE pulse 882. Similarly, transition 804 in DATA 810 results in ERROR pulse 872 and REFERENCE pulse 882.

Again, the duration that DATA 810 is delayed to generate D2 840 may vary from edge 842 to edge 843. This time period is shown as t₃ 847. Specifically, the delay may be zero at a minimum. At a maximum, it should be such that the storage element that generates Q1 850 has sufficient setup (and hold) times that it is able to properly latch data, and that its clock-to-Q delay does not become excessive due to amplitude-modulation phase-modulation effects. If a zero duration for this time is assumed, the range over which this delay may vary is one half of a clock cycle plus the delay of D1 less a clock-to-Q delay for the circuit that generates Q1 850.

Again, these delay, and similar delays in other embodiments, which in Figure 4 is generated by the first and second delay elements 410 and 420, may be fixed or variable. Values may be determined by simulation, and the delay elements may be designed accordingly. They may be controlled at least partly by some number of capacitors or resistors, the number of which may be varied by later changes to one or more of the metal or other conductive layers. These delays may also be varied by other mechanisms, such as trim pads, laser trimming, fuses, and the like. They may also be programmably controlled.

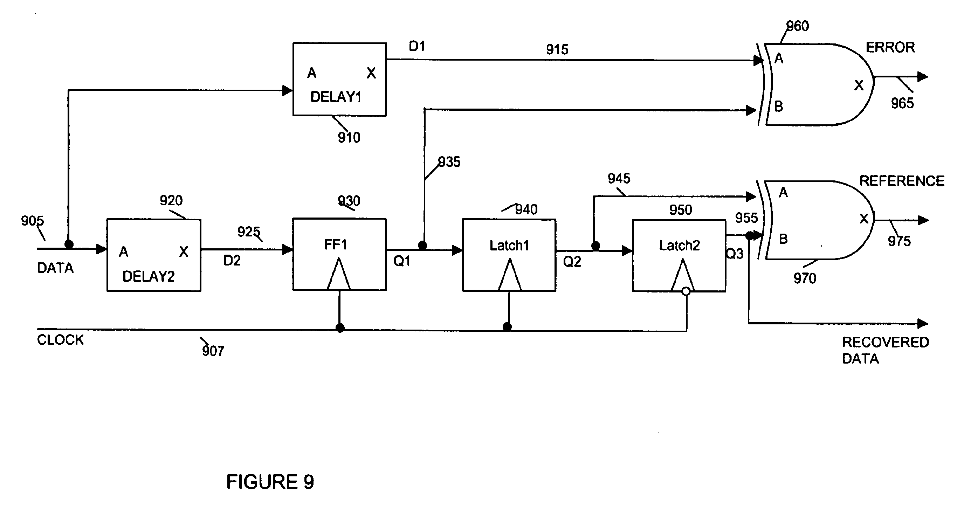

Figure 9 is a block diagram of a phase detector consistent with an embodiment of the present invention. This phase detector may be used as the phase detector 220 in Figure 2. Alternately, it may be used as the phase detector in other CDR architectures. For example, it may be used in an architecture having a charge pump between the phase detector and loop filter. The phase detector shown may be used in a CDR in a fiber optic transceiver, as shown in Figure 1. Alternately, it may be used in a CDR in other systems.

Included are a first delay element 910, a second delay element 920, flip-flop 930, first latch 940, second latch 950, and exclusive-OR (XOR) gates 960 and 970. In a specific embodiment, the flip-flop 930 is a negative-edge triggered device. That is, flip-flop 930 changes state on falling edges of the clock signal. Latches 940 and 950 pass data when their clock input is high and latch data when their clock input is low. With this configuration the phase detector aligns data centers to clock falling edges. If no offset current Ioffset 242 is applied, the falling edges of the clock are centered in the (averaged) middle of the incoming data bits. This "window centering" ensures that as the data eye closes due to noise, jitter, and the like, data recovery remains optimum, given a symmetrical distortion pattern. In other embodiments, a positive-edge triggered flip-flop may be used, and the latches may pass data when their clock inputs are low. In this alternate configuration, the phase detector aligns the centers of the data bits to the clock rising edges. Again, in either configuration, if an offset current Ioffset 242, or similar current is applied to the loop feature or charge pump, the edges shift relative to the center of the average data bit.

All signal paths shown may be differential or single-ended. For example, Q1 935 may be a differential signal including flip-flop 930 output signals Q and its complement, QBAR. In a specific embodiment, all signal paths are differential, except the error and reference outputs, which together essentially form a differential signal. Using differential signals reduces the jitter caused by noise from such sources as the power supply and bias lines.

Modifications to this block diagram will be readily apparent to one skilled in the art. For example, a combination of AND and OR gates may replace the XOR gates, or two latches may replace the flip-flop, making for a four latch configuration.

DATA on line 905 is received by the second delay element 920, which provides an output D2 on line 925 that drives flip-flop 930. The flip-flop 930 is clocked by the CLOCK signal on lines 907 from a VCO or other clock or periodic source. On each CLOCK falling edge, the data on lines 905 is latched by the flip-flop 930 and held at the Q output as signal Q1 on line 935. The signal Q1 on line 935 is passed by latch 940 when the clock signal on line 907 is high, and latched when the clock is low. Latch 940 provides an output signal Q2 on line 945. The output signal Q2 on line 945 is passed by the second latch 950 when the clock signal on line 907 is low and latched when the clock signal is high, thereby generating signal Q3 on line 955.

The first delay element 910 delays the data signal and provides an output D 1 on line 915. In a specific embodiment, the delay through the delay element 910 approximately equals the clock-to-Q delay of flip-flop 930. Alternately, this delay may be less than or greater than the clock-to-Q delay. XOR gate 950 receives Q1 on line 935 and D1 on line 915 as inputs. The output of XOR gate 960 is the ERROR signal on line 965. XOR gate 970 has Q2 on line 945 and Q3 on line 955 as inputs. The output of XOR gate 970 is the REFERENCE signal on line 975.

As before, the delays through the first and second delay elements 910 and 920 can either be fixed or variable. Values for the delays may be determined by simulation, and the delay elements may be designed accordingly. They may be controlled at least partly by some number of capacitors or resistors, the number of which may be varied by later changes to one or more of the metal or other conductive layers. The delays may also be varied by other mechanisms, such as trim pads, laser trimming, fuses, and the like. They may also be programmably controlled. The two delays may be implemented in the same or similar manner, or they may be implemented in different manners.

As can be seen, the recovered data is provided on line 955 without the requirement of an additional data regeneration circuit. This saves not only die area if this circuit is integrated, but reduces power supply current as well. Also, the insertion of the second delay 920 allows centering of the data recovery timing, but does not significantly disrupt the clock recovery function of this circuit. Moreover, if the static phase operating point is shifted, for example by the addition of an offset current Ioffset 242, the data recovery timing of this circuit can be corrected by properly adjusting the delay of the second delay element.

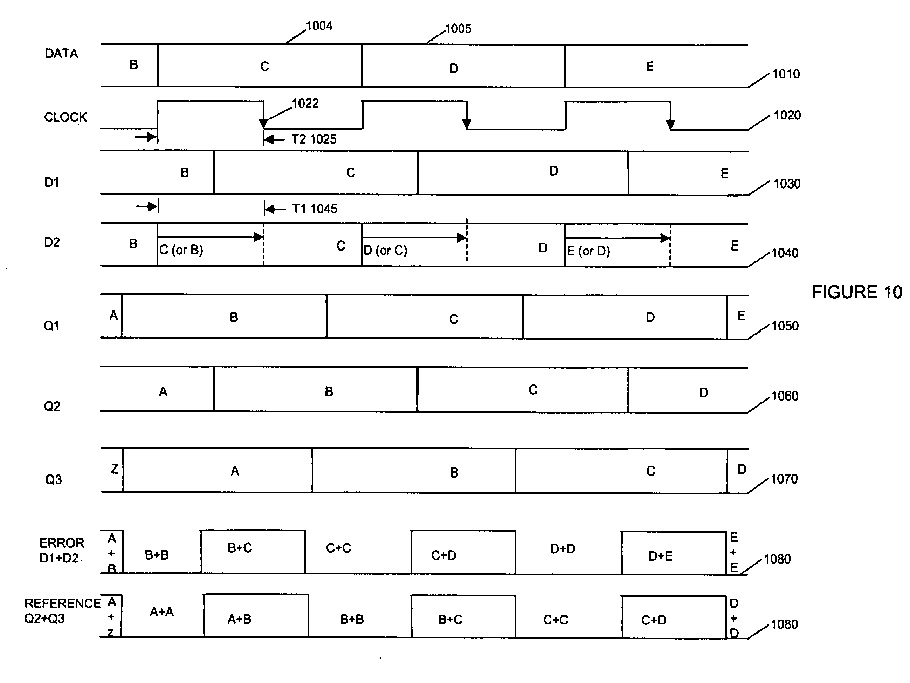

Figure 10 is a generalized timing diagram of signals in a phase detector consistent with one embodiment of the present invention, such as the block diagram of Figure 9. But this timing diagram is not limited to the circuit of Figure 9 and may be generated by other circuitry consistent with the present invention. Included are inputs DATA 1010 and CLOCK 1020, and resulting signals D1 1030, D2 1040, Q1 1050, Q2 1060, Q3 1070, ERROR 1080, and REFERENCE 1090. Data bits, such as 1004 and 1005, have a duration approximately equal to one clock cycle. Each data bit may be high or low, and the DATA signal 1010 may transition or remain constant from one bit to the next.

Q1 1050 is DATA 1010 retimed. There is typically delay between a transition of Q1 1050 as compared to the falling edges of the CLOCK 1020, particularly if Q1 is generated by a flip-flop clocked by falling edges of the CLOCK signal 1020 and having DATA 1010 as its D input. Q2 1060 is Q1 1050 delayed by one half clock cycle. Q3 1070 is Q2 1060 delayed an additional half clock cycle. There may be a delay between transitions of Q2 1060 and Q3 1070 as compared to the edges of the CLOCK 1020, particularly if Q2 and Q3 are generated by latches. ERROR 1080 is generated by XORing D1 1030 and Q1 1060. REFERENCE 1090 is generated by XORing Q2 1060 and Q3 1070.

Signals D1 1030 and D4 1040 are delayed versions of DATA 1010. The duration of the delay of D 1 may be approximately equal to the clock-to-Q delay of the circuit that generates Q1 1050, for example, the flip-flop 930 in Figure 9. Alternately, this duration may be shorter or longer than this clock-to-Q delay. For example, the delay may be longer, such that the delay of D2 may be varied over a greater range without significantly effecting the clock recovery function of the phase detector.

The delay of D2 may range from zero to approximately the minimum setup time of the circuit or circuits used to generate Q1 1050. This range is shown as t₁ 1045. By varying this delay, the setup time of this circuit can be varied, thus allowing improved data regeneration. Specifically, in the circuit of Figure 9, the setup time for the flip-flop 930 is the time from the edge 1042 of D2 1040 to the falling edge 1022 of the CLOCK 1020, shown as t₂ 1025.

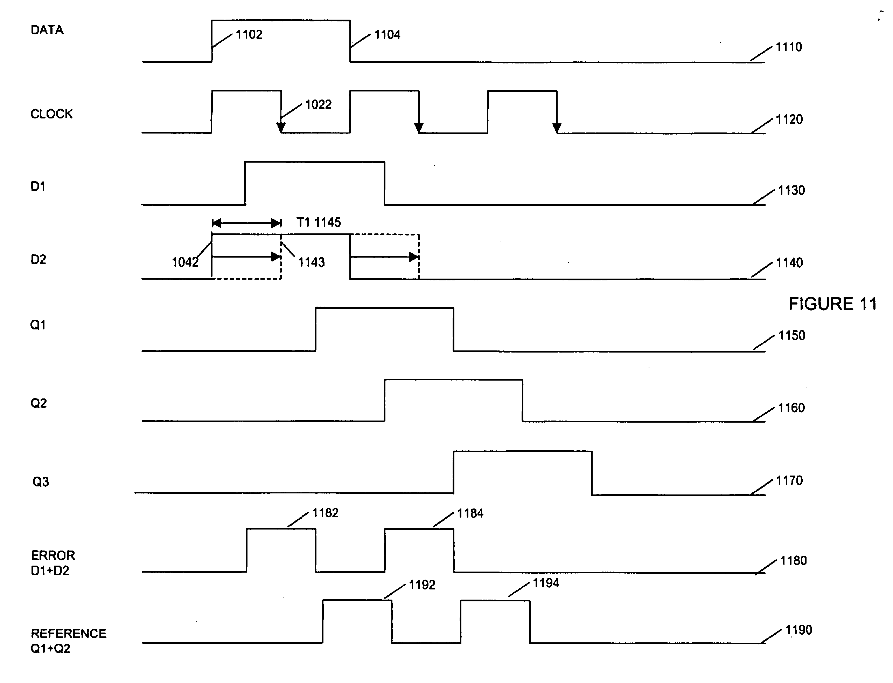

Figure 11 shows this for specific DATA transitions 1102 and 1104. Included are inputs DATA 1110 and CLOCK 1120, and resulting signals D1 1130, D2 1040, Q1 1150, Q2 1160, Q3 1170, ERROR 1180, and REFERENCE 1190. The transition 1102 in DATA 1110 results in a pulse in ERROR waveform 1180, specifically 1182, and a REFERENCE bit 1192. Similarly, transition 1104 results in ERROR pulse 1184 and REFERENCE pulse 1194.

Again, the duration that DATA 1110 is delayed to generate D2 1140 may vary from edge 1142 to edge 1143. This time period is shown as t₃ 1145. Specifically, the delay may be zero at a minimum. At a maximum, it should be such that the storage element that generates Q1 850 has sufficient setup (and hold) times that it is able to properly latch data, and that its clock-to-Q delay does not become excessive due to amplitude-modulation phase-modulation effects. If a zero time for this is assumed, the range over which this delay may vary is one half of a clock cycle plus the delay of D1 less a clock-to-Q delay for the circuit that generates Q1 1150.

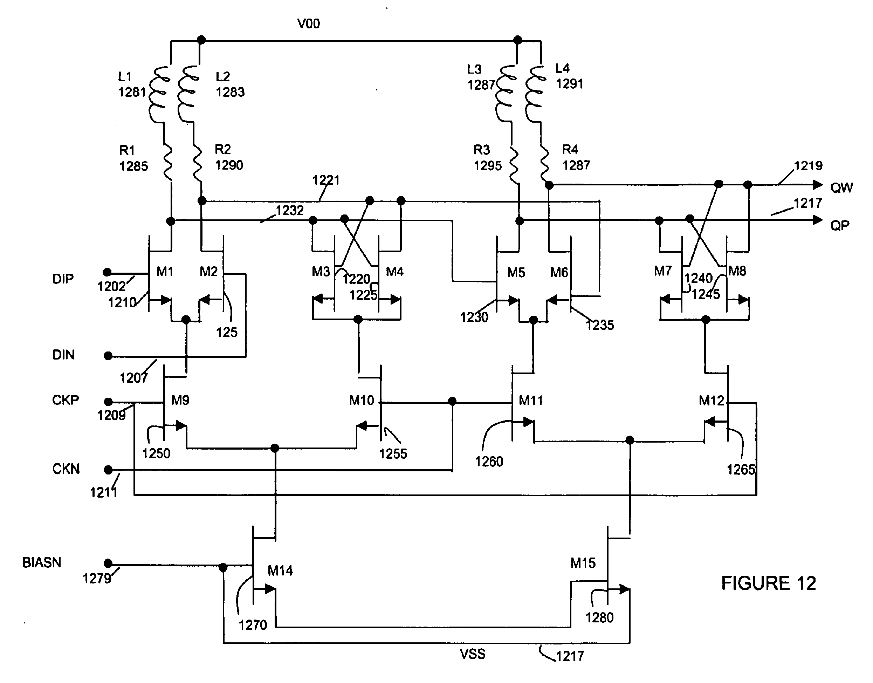

Figure 12 is a schematic for an exemplary implementation of a negative-edge triggered flip-flop based on current-controlled CMOS (C3MOS) logic with inductive broadbanding, which may be used as the flip-flops 430 or 440 in Figure 4, flip-flop 430 in Figure 9, or other flip-flops in other embodiments of the present invention. The concept of C3MOS logic with inductive broadbanding is described in greater detail in commonly-assigned U.S. patent application number 09/610,905, filed July 6, 2000, entitled "Current-Controlled CMOS Circuits With Inductive Broadbanding", by Michael Green. One skilled in the art appreciates that other flip-flops can be used, for example a bipolar flip-flop, a flip-flop made of GaAs on silicon, or other types of flip-flops could be used. Another embodiment of a flip-flop is described in commonly-assigned U.S. patent application number 09/784,419, filed February 15, 2001, entitled "Linear Full-Rate Phase Detector & Clock & Data Recovery Circuit", by Jun Cao. Alternately, as with all the included schematics, current source loads, p-channel loads operating in their triode regions, or source follower outputs could be used. N-channel metal oxide semiconductor field effect transistors (MOSFET, or NMOS) are shown, but alternately, as with all the included schematics, p-channel (PMOS) devices could be used.

The flip-flop is made up of two latches, a master and a slave, in series. In this example, a master latch includes input differential pair M1 1210 and M2 1215, latching devices M3 1220 and M4 1225, clock pair M9 1250 and M10 1255, current source M14 1270, and series combination loads L1 1281 and R1 1285, and L2 1283 and R2 1290. A slave latch includes input differential pair M5 1230 and M6 1235, latching pair M7 1240 and M8 1245, clock pair M11 1260 and M12 1265, current source M15, 1280, and series combination loads L3 1287 and R3 1295, and L4 1291 and R4 1297. Data inputs DIP and DIN are received on lines 1202 and 1207, clock inputs CKP and CKN are received on lines 1209 and 1211, a bias voltage BIASN is received on line 1279, and outputs QP (true) and QN (complementary) are provided on lines 1217 and 1219.

The power supplies are shown here as VDD on line 1207 and VSS on line 1217. The VDD and VSS voltages for this and all the included figures are typically equal, but are not so limited. VDD may be a positive supply above ground. For example, VDD may be 5.0, 3.3, 2.5, 1,8, or other supply voltage. Alternately, VDD may be ground. VSS may be ground. Alternately, VSS may be below ground, such as -1.8, -2.5, -3.3, -5.0, or other voltage. In other embodiments, other voltages may be used.

Bias voltage BIASN is applied to the gates of M 14 1270 and M15 1280 relative to their sources, which are coupled to line 1217. This bias voltage generates currents in the drains of M14 1270 and M15 1280. When the clock signal is high, the signal level of CKP on line 1209 is higher than the signal level of CKN on line 1211, and the master latch is in the pass mode and the slave latch is in the latched mode. Specifically, the drain current of M14 1270 is passed through M9 1250 to the input differential pair M1 1210 and M2 1215, and the drain current of M15 passes through device M12 1265 to the latching pair M7 1240 and M8 1245. If the voltage at D is high, the voltage on line DIP 1202 is higher than the voltage DIN on line 1207 and the drain current of M9 flows through device M1 1210 into load resistor R1 1285 and load inductor L1 1281, thereby lowering the voltage at the drain of M1 1210. The device M2 1215 is off and the voltage at its drain is high. If the voltage at QN on line 1219 is high, the drain current from M 12 1265 passes through device M7 1240 across the load resistor R3 1295 and load inductor L3 1287, and the signal QP on line 1217 is low.

When the clock signal is low, the signal level of CKN on line 1211 is higher than the signal CKP on line 1209 and the master is latched and the slave passes data. The drain current of M14 1270 passes through M10 1255, and the drain current of M15 1280 passes through device M11 1260. If the signal level at DIP had previously been high such that the voltage at the drain of M1 1210 is low, the drain current of M10 1255 passes through device M3 1220 across the load resistor R1 1285 and load inductor L1 1281, thus keeping the voltage at the drain of M1 1210 low. Furthermore, latch pair M7 1240 and M8 1245 are off, and input pair M5 1230 and M6 1235 are on, and follow the data signal provided by latch pair M3 1220 and M4 1225. In this example, M6 1235 is on, and conducts the drain current of M11 1260 to the load resistor R4 1297 and load inductor L4 1291, pulling down QN on line 1219, and allowing QP on 1217 to return high. Therefore, after each clock falling edge, the signal voltage CKN on line 1211 exceeds in the signal voltage CKP on line 1209, and the data at the input port DIP 1202 and DIN 1207 is latched by the master latch and output by the slave latch on lines QP 1217 and QN 1219.

If this flip-flop is used for the flip-flop in Figure 4, the following should be noted. If the signals are differential, DIP, CKP and QP correspond to the D, clock, and Q ports of the flip-flop in Figure 4. If single-ended signals are used, DIN and CKN are coupled to bias voltages that preferably have a DC voltage equal to the average signal voltage at DIP and CKP. This circuit can be changed into a positive-edge triggered flip-flop by reversing the CKP and CKN lines.

The clock-to-Q delay for this circuit can be described qualitatively by way of an example. Let the initial conditions be such that the clock input CKP is high, the output voltage QP on line 1217 is low, and the D input DIP is high. The drain current of M15 1280 flows through M12 1265 through M7 1240 into the load resistor R3 1295 and load inductor L3 1287. Also, the drain current of M14 1270 flows through M9 1250, and through device M1 1210 through the load resistor R1 1285 and load inductor 1281. Accordingly, the voltage on line 1223 is lower than the voltage on line 1221. After the following edge of the clock signal, CKN on line 1211 is higher than CKP on line 1209. Thus, the drain current of M 15 1280 switches from M12 1265 to M11 1260. M11 1260 directs current through M6 1235, where it flows through load resistor R4 1297 and load inductor L4 1291. QP on line 1217 goes high and QN on line 1219 goes low. Thus, the clock-to-Q delay is the delay time it takes for M11 1260 to turn on and conduct the current of M15 1280, plus the time required for M6 to turn on and conduct current thereby changing voltage QN on line 1219 and QP on line 1217.

As the setup or hold times decrease for this flip-flop, the differential signal level at the drains of M1 1210 and M2 1215 are reduced. This means that there is less drive available to switch M5 1230 and M6 1235. As a result, these propagation delay through the differential pair M5 1230 and M6 1235 is increased. Accordingly, the clock-to-Q delay is increased.

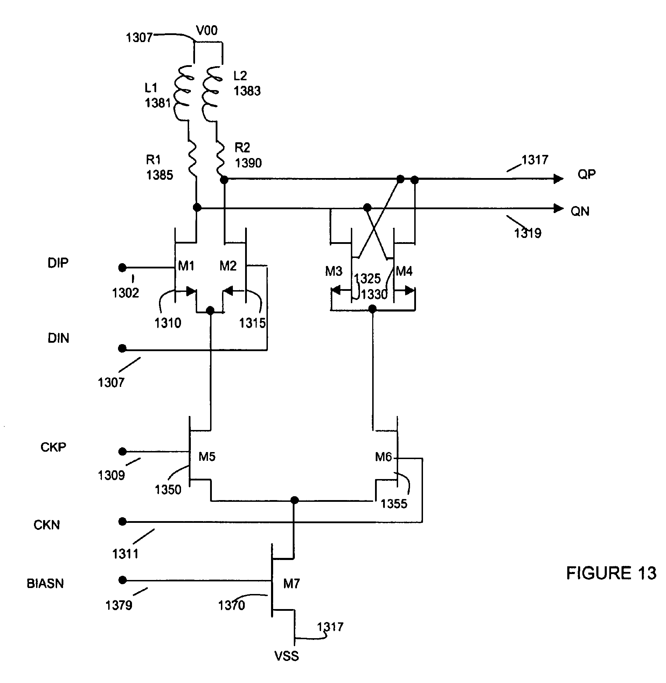

Figure 13 is a schematic of a latch with inductive broadbanding that may be used as latches 940 and 950 in Figure 9, or as other latches in other embodiments of the present invention. Alternately, other types of latches may be used, for example cross coupled logic gates may be used. Included are input differential pair M1 1310 and M2 1315, latching pair M3 1320 and M4 1325, clock pair M5 1350 and M6 1355, current source M7 1370, and series loads of inductor L1 1381 and resistor R1 1385, and inductor L2 1338 and resistor R2 1390. Data inputs DIP and DIN are received on lines 1302 and 1307, clock inputs CKP and CKN are received on lines 1309 and 1311, bias voltage BIASN is received on line 1379, and outputs QP (true) and QN (complementary) are provided on lines 1317 and 1319.

The bias voltage BIASN is applied on line 1379 to the gate of M7 1370 relative to its source that is coupled to line 1317. When the clock input signal is high, the signal voltage CKP on line 1309 is higher than the signal voltage CKN on 1311 and the drain current of M7 1370 flows through M5 1350 to the input differential pair M1 1310 and M2 1315. When the D input is high, the signal voltage DIP on line 1302 is higher than the signal voltage DIN on line 1307 and the drain current from M5 1350 flows through device M1 1310 through load inductor L1 1381 and resistor R1 1385 pulling the signal voltage QN on line 1319 low and allowing the signal voltage QP on line 1317 to go high. When the clock signal goes low, the voltage CKN on line 1311 is high and signal voltage CKP on line 1309 is low. Thus, device M6 directs the drain current from M7 1370 to the latching pair M3 1320 and M4 1325, which latch the data at the QP 1317 and QN 1319 outputs.

If this latch is used as the latch in Figure 9, the following should be noted. If the signals are differential, DIP, CKP and QP correspond to the D, clock, and Q ports of the latch in Figure 4. If single-ended signals are used, DIN and CKN are coupled to bias voltages that preferably have a DC voltage equal to the average signal voltage at DIP and CKP.

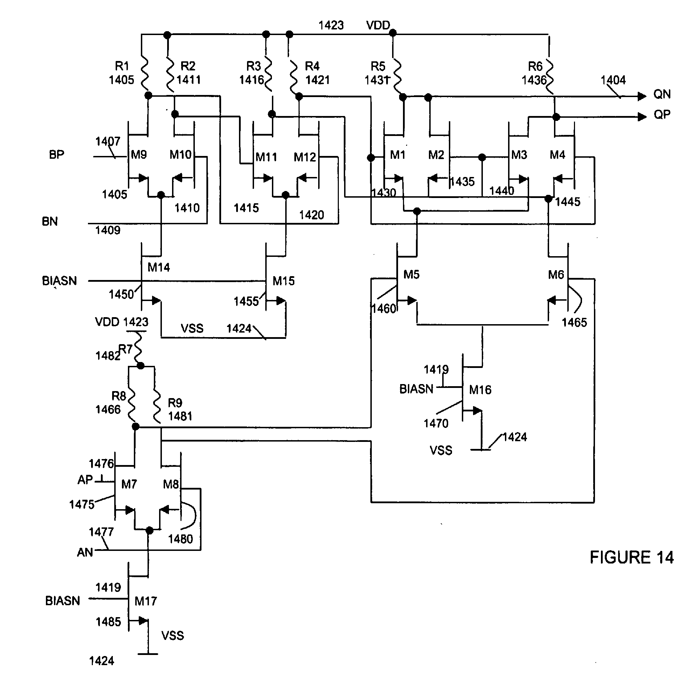

Figure 14 and is an exemplary high speed XOR gate implemented using C3MOS logic that may be used with various embodiments of the present invention. For example, this XOR gate may be used as XOR gates 450 and 460 in Figure 4, or XOR gates 960 and 970 in Figure 9. Alternately, other XOR gates may be used, such as a bipolar XOR gate. Included are B input buffers M9 1405 and M10 1410, and M11 1415 and M12 1420, and A input buffer M7 1475 and M8 1480. An XOR core made up of devices M1 1430, M2 1435, M3 1440, M4 1445, M5 1460, and M6 1465, is also shown. Inputs AP and AN are received on lines 1476 and 1477, inputs BP and BN are received on lines 1407 and 1409, bias voltage BIASN is received on line 1419, and QP (true) and QN(complementary) outputs are provided on lines 1412 and 1414. Current sources M14 1450, M15 1455, M16 1470, and M17 1485, are biased with BIASN such that a current is produced in their drains. The BIASN voltage applied to all these devices may be equal to each other. Alternately, different BIASN voltages may be used for the buffers and the core. Further, the buffers may have differing BIASN voltages. Also, this BIASN voltage may the same or different voltage as the BIASN voltage in Figures 12 and 13.

Signals at the A input steer the drain currents of M16 1470 through either M5 1460 or M6 1465. The signal at the B input steers the current to the load resistors thereby generating voltage outputs at QP and QN on lines 1412 and 1414. The connections are such that QP is high when the signal at either, but not both, the A input and the B input are high. To match the delay from input to output, two buffers are used in the B path, and one buffer is used in the A path. This is because the A input steers the lower devices M5 and M6, which then drive upper devices M1 through M4. But the B input drives devices M1 to M4 directly. Thus, to compensate for the delay through M5 1460 and M6 1465, an extra buffer is inserted in the B path. Resistor R7 1482 lowers the common mode voltage of the output of the A input buffer, which improves the transient response of the lower differential pair M5 1460 and M6 1465.

An alternate embodiment for an XOR gate can be found in commonly assigned U.S. patent application number 09/782,687, filed February 12, 2001, entitled "Linear Half-Rate Phase Detector and Clock and Data Recovery Circuit," by Jafar Savoj. Also, other architectures which may be used to implement some of the circuits herein can be found in commonly assigned U.S. patent application number 09/484,856, filed January 18, 2000, entitled "C3MOS Logic Family," by Armond Hairapetian.

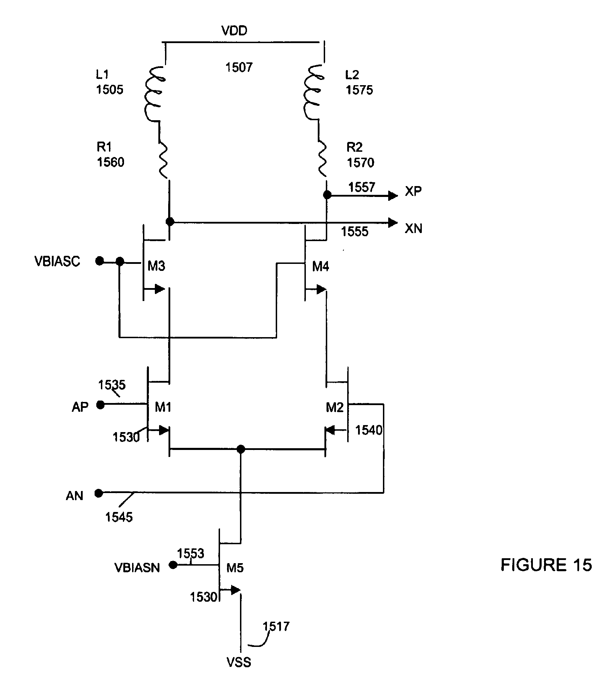

Figure 15 is a schematic of an exemplary circuit implementation for a delay circuit with inductive broadbanding that may be used as the delay elements in Figures 4 and 9. One skilled in the art appreciates that this delay block could be designed several different ways. For example, an RC network could be used. Included are input pair devices M1 1530 and M2 1540, cascode devices M3 1510 and M4 1520, series loads of inductor L1 1565 and R1 1560, and L2 1575 and R2 1570, and current source device M5 1550. Inputs AP and AN are received on lines 1535 and 1545, bias voltages BIASN and VBIASC are received on lines 1553 and 1515, and outputs XP (true) and XN (complementary) are provided on lines 1557 and 1555.

VBIASC may be tied to VDD or other appropriate bias point. An input signal is applied at the A port, AP on line 1535 and AN on line 1545, to the first input pair M1 1530 and M2 1540. Bias voltage BIASN is applied to the gate of M5 relative to its source terminal that is coupled to line 1517. BIASN may be the same bias line as was used in Figure 4A or it may be a different bias voltage. This voltage generates a current in the drain of M5 1550. If the voltage at the A input port is high, the signal voltage AP on line 1535 is higher than the signal level of AN on line 1545 and the drain current of M5 1550 flows through the device M1 1530, through cascode device M3 1510, to the load resistor R1 1560 and load inductor L1 1565, pulling the voltage XN on line 1555 low. Conversely, if the signal at the A port is low, the voltage signal at AP is lower than the signal level at AN and the diain current of M5 1530 flows through device M2 1540, through cascode device M4 1520, to the load resistor R2 1570 and load inductor L2 1575, pulling output XP on line 1557 low. In this way, a signal applied to input port A on lines 1535 and 1545 results in a delayed signal appearing at lines at XP 1557 and XN 1555.

In a specific embodiment, die area is conserved by not including inductors L1 1565 and L2 1575 in the loads. Rather, the load resistors R1 1560 and R2 1570 connect directly between VDD line 1507 and the drains of M3 1510 and M4 1520. In this embodiment, the width of device M5 1550, and thus its drain current is decreased, and the value of resistors R1 1560 and R2 1570 are increased relative to the flip-flop and latch such that the delay through this block matches the clock-to-Q delays of the storage elements. Thus, the voltage swing of the delay block is substantially equal to the latch and flip-flop. In this way, sufficient matching may be retained while saving the area that two inductors would otherwise consume.

If this delay element is used as the delay elements in Figures 4 or 9, the following should be noted. If the signals are differential, AP and XP correspond to the A and X ports of the latch in Figure 4. If single-ended signals are used, AN is coupled to a bias voltage that preferably has a DC voltage equal to the average signal voltage at AP.

The foregoing description of specific embodiments of the invention has been presented for the purposes of illustration and description. It is not intended to be exhaustive or to limit the invention to the precise form described, and many modifications and variations are possible in light of the teaching above. The embodiments were chosen and described in order to best explain the principles of the invention and its practical applications to thereby enable others skilled in the art to best utilize the invention in various embodiments and with various modifications as are suited to the particular use contemplated.

## Claims

1. A method of recovering data from a data signal (510, 610, 710, 1010, 1110) comprising:
receiving a clock signal (520, 620, 720, 820, 1020, 1120) having a first clock frequency, and alternating between a first level and a second level;
receiving the data signal (510, 610, 710, 1010, 1110) having a first data rate, the first data rate being substantially equal to the first clock frequency;
providing a first signal (530 ,630, 730, 830, 1030) by delaying the data signal (510, 610, 710, 1010, 1110) a first duration; **characterized by**
providing a second signal (540 ,640, 740, 840, 1040) by delaying the data signal (510, 610, 710, 1010, 1110) a second duration, the second duration being variable between zero and such a value that a transition edge of the second signal is near a transition edge of the clock signal;
providing a third signal (550, 650, 750, 850, 1050, 1150) by storing the second signal (540 ,640, 740, 840, 1040) when the clock signal (520, 620, 720, 820, 1020, 1120) alternates from the first level to the second level;
providing a fourth signal (560, 660, 760, 860, 1060, 1160) by storing the third signal (550, 650, 750, 850, 1050, 1150) when the clock signal (520, 620, 720, 820, 1020, 1120) alternates from the second level to the first level;
providing an error signal (570, 670, 770, 870, 1070) by performing an exclusive-OR function on the first signal (530 ,630, 730, 830, 1030) and the third signal (550, 650, 750, 850, 1050, 1150); and
providing a reference signal (580, 680, 780, 880, 1080) by combining the third signal (550, 650, 750, 850, 1050, 1150) and the fourth signal (560, 660, 760, 860, 1060, 1160).

2. The method of claim 1 further comprising:
applying the error signal (570, 670, 770, 870, 1070) and the reference signal (580, 680, 780, 880, 1080) to a loop filter (240) to generate a loop filter output.

3. The method of claim 1 wherein the fourth signal (560, 660, 760, 860, 1060, 1160) includes the recovered data.

4. The method of claim 3 wherein the providing the error signal (570, 670, 770, 870, 1070) and providing the reference signal (580, 680, 780, 880, 1080) are done by exclusive-OR gates (450, 460, 960, 970).

5. The method of claim 3 wherein the first delay is approximately equal to a clock-to-Q delay of a flip-flop (430, 440, 930) which stores the second signal (540, 640, 740, 840, 1040).

6. The method of claim 1 wherein the second duration may be varied to optimize data recovery.

7. A phase detector for recovering data from a data signal (510, 610, 710, 1010, 1110) having a first data rate useing a clock signal (520, 620, 720, 820, 1020, 1120) having a first clock frequency and alternating between a first level and a second level; the first data rate being substantially equal to the first clock frequency; comprising:
a first delay element (410, 910) configured to delay the data signal (510, 610, 710, 1010, 1110) a first duration; **characterized by**
a second delay element (420, 920) configured to delay the data signal (510, 610, 710, 1010, 1110) a second duration, the second duration being variable between zero and such a value that a transition edge of the second signal is near a transition edge of the clock signal;
a first storage device (438, 930) configured to receive and store an output of the second delay element (420, 920) and output a first data recovery signal and a second data recovery signal when the clock signal alternates from the first level to the second level;
a second storage device (440, 940) configured to receive and store the second data recovery signal and output a third data recovery signal when the clock signal alternates from the second level to the first level;
a first logic circuit (450, 960) configured to perform an exclusive-OR function on an output of the first delay element (410, 910) and the first data recovery signal to provide an error signal (570, 670, 770, 870, 1070); and
a second logic circuit (460, 970) configured to receive an output of the first storage device (430, 930) and the second storage device (440, 940) and provide a reference signal (580, 680, 780, 880, 1080).

8. The phase detector of claim 7 wherein the first storage device includes a flip-flop (430, 440, 930).

9. The phase detector of claim 8 wherein the flip-flop (430, 440, 930) receives the clock signal (520, 620, 720, 820, 1020, 1120), the clock signal (520, 620, 720, 820, 1020, 1120) having first edges from the first level to the second level and second edges from the second level to the first level.

10. The phase detector of claim 9 wherein the flip-flop (430, 440, 930) stores the received data signal (510, 610, 710, 1010, 1110) on the first edges of the clock.

11. The phase detector of claim 10 wherein the first edges are falling edges and the second edges are rising edges.

12. The phase detector of claim 7 wherein a delay through the second delay element (420, 920) is set such that data recovery is done by the first storage device.

13. The phase detector of claim 7 wherein the second duration may be varied to optimize data recovery by the phase detector (220).

14. The phase detector of claim 7 wherein
said first delay element (410, 910) is coupled to an input port;
said second delay element (420, 920) is coupled to the input port;
at least one flip-flop (430, 440, 930) having an said first storage device (430, 930) includes input coupled to an output of the second delay element (420, 920), and a clock input (CKP, CKN) is coupled to a clock port, and said at least one flip-flop (430, 440, 930) is configured to output the first data recovery signal and the second data recovery signal based on a delay of the second delay element (420, 920).

15. The phase detector of claim 14 wherein the input port is configured to receive the received data signal (510, 610, 710, 1010, 1110), and the received data signal (510, 610, 710, 1010, 1110) is a differential signal.

16. The phase detector of claim 14 wherein the clock port is configured to receive a differential clock signal (520, 620, 720, 820, 1020, 1120).

17. The phase detector of claim 14 wherein the first logic circuit and the second logic circuit are exclusive-OR gates (450, 460, 960, 970).

18. The phase detector of claim 14 wherein the first logic circuit provides a reference signal (580, 680, 780, 880, 1080), and the second logic circuit provides an error signal (570, 670, 770, 870, 1070).

19. The phase detector of claim 14, wherein the phase detector (220) is included in an optical transceiver.

20. The optical receiver of claim 19 wherein the optical receiver is coupled to the optical transmitter of the optical transceiver.

21. The phase detector of claim 14, wherein the phase detector (220) is coupled to a receive amplifier of a system for receiving and transmitting optical signals, the system for receiving and transmitting optical signals comprising:
a light emitting diode (190), configured to transmit optical signals;
a transmitter coupled to the light emitting diode (190);
a photo-diode (110), configured to receive optical signals; and
the receive amplifier (120, 130) coupled to the photo-diode (110).

22. The phase detector of claim 14 wherein the second delay circuit provides a delay that is variable.

23. The phase detector of claim 22 wherein the delay may be varied to optimize data recovery.

## Patentansprüche

1. Verfahren zur Wiederherstellung von Daten aus einem Datensignal (510, 610, 710, 1010, 1110), das umfasst:
Empfangen eines Taktsignals (520, 620, 720, 820, 1020, 1120) mit einer ersten Taktfrequenz, und Wechseln zwischen einem ersten Pegel und einem zweiten Pegel;
Empfangen des Datensignals (510, 610, 710, 1010, 1110) mit einer ersten Datenrate, wobei die erste Datenrate im Wesentlichen gleich der ersten Taktfrequenz ist;
Bereitstellen eines ersten Signals (530, 630, 730, 830, 1030) durch Verzögern des Datensignals (510, 610, 710, 1010, 1110) um eine erste Dauer, **gekennzeichnet durch**
Bereitstellen eines zweiten Signals (540, 640, 740, 840, 1040) **durch** Verzögern des Datensignals (510, 610, 710, 1010, 1110) um eine zweite Dauer, wobei die zweite Dauer zwischen Null und einem Wert variiert werden kann, den eine Übergangsflanke des zweiten Signals nahe einer Übergangsflanke des Taktsignals ist;
Bereitstellen eines dritten Signals (550, 650, 750, 850, 1050, 1150) **durch** Speichern des zweiten Signals (540, 640, 740, 840, 1040), wenn das Taktsignal (520, 620, 720, 820, 1020, 1120) von dem ersten Pegel zu dem zweiten Pegel wechselt;
Bereitstellen eines vierten Signals (560, 660, 760, 860, 1060, 1160) durch Speichern des dritten Signals (550, 650, 750, 850, 1050, 1150), wenn das Taktsignal (520, 620, 720, 820, 1020, 1120) von dem zweiten Pegel zu dem ersten Pegel wechselt;
Bereitstellen eines Fehlersignals (570, 670, 770, 870, 1070) **durch** Durchführen einer exklusiven ODER-Funktion für das erste Signal (530, 630, 740, 830, 1030) und das dritte Signal (550, 650, 750, 850, 1050, 1150); und
Bereitstellen eines Referenzsignals (580, 680, 780, 880, 1080) **durch** Kombinieren des dritten Signals (550, 650, 750, 850, 1050) und des vierten Signals (560, 660, 760, 860, 1060, 1160).

2. Verfahren nach Anspruch 1, das des Weiteren umfasst:
Anlegen des Fehlersignals (570, 670, 770, 870, 1070) und des Referenzsignals (580, 680, 780, 880, 1080) an ein Schleifenfilter (240), um einen Schleifenfilterausgang zu erzeugen.

3. Verfahren nach Anspruch 1, wobei das vierte Signal (560, 660, 760, 860, 1060, 1160) die wiederhergestellten Daten enthält.

4. Verfahren nach Anspruch 3, wobei das Bereitstellen des Fehlersignals (570, 670, 770, 870, 1070) und das Bereitstellen des Referenzsignals (580, 680, 780, 880, 1080) mittels exklusiver ODER-Gates (450, 460, 960, 970) erfolgt.

5. Verfahren nach Anspruch 3, wobei die erste Verzögerung ungefähr gleich einer Takt-zu-Q-Verzögerung eines Flip-Flops (430, 440, 930) ist, das das zweite Signal (540, 640, 740, 840, 1040) speichert.

6. Verfahren nach Anspruch 1, wobei die zweite Dauer variiert werden kann, um die Datenwiederherstellung zu optimieren.

7. Phasendetektor zum Wiederherstellen von Daten aus einem Datensignal (510, 610, 710, 1010, 1110) mit einer ersten Datenrate unter Verwendung eines Taktsignals (520, 620, 720, 820, 1020, 1120) mit einer ersten Taktfrequenz, und Wechseln zwischen einem ersten Pegel und einem zweiten Pegel, wobei die erste Datenrate im Wesentlichen gleich der ersten Taktfrequenz ist, wobei der Phasendetektor aufweist:
ein erstes Verzögerungselement (410, 910), das so konfiguriert ist, dass es das Datensignal (510, 610, 710, 1010, 1110) um eine erste Dauer verzögert, **gekennzeichnet durch**
ein zweites Verzögerungselement (420, 920), das so konfiguriert ist, dass es das Datensignal (510, 610, 710, 1010, 1110) um eine zweite Dauer verzögert, wobei die zweite Dauer zwischen Null und einem Wert variiert werden kann, den eine Übergangsflanke des zweiten Signals nahe einer Übergangsflanke des Taktsignals ist;
eine erste Speichervorrichtung (430, 930), die so konfiguriert ist, dass sie einen Ausgang des zweiten Verzögerungselements (420, 920) empfängt und speichert, und ein erstes Datenwiederherstellungssignal und ein zweites Datenwiederherstellungssignal ausgibt, wenn das Taktsignal von dem ersten Pegel zu dem zweiten Pegel wechselt;
eine zweite Speichervorrichtung (440, 940), die so konfiguriert ist, dass sie das zweite Datenwiederherstellungssignal empfängt und speichert, und ein drittes Datenwiederherstellungssignal ausgibt, wenn das Taktsignal von dem zweiten Pegel zu dem ersten Pegel wechselt;
eine erste Logikschaltung (450, 960), die so konfiguriert ist, dass sie eine exklusive ODER- Funktion für einen Ausgang des ersten Verzögerungselements (410, 910) und das erste Datenwiederherstellungssignal durchführt, um ein Fehlersignal (570, 670, 770, 870, 1070) bereitzustellen; und
eine zweite Logikschaltung (460, 970), die so konfiguriert ist, dass sie einen Ausgang der ersten Speichervorrichtung (430, 930) und der zweiten Speichervorrichtung (440, 940) empfängt und ein Referenzsignal (580, 680, 780, 880, 1080) bereitstellt.

8. Phasendetektor nach Anspruch 7, wobei die erste Speichervorrichtung ein Flip-Flop (430, 440, 930) aufweist.

9. Phasendetektor nach Anspruch 8, wobei das Flip-Flop (430, 440, 930) das Taktsignal (520, 620, 720, 820, 1020, 1120) empfängt, wobei das Taktsignal (520, 620, 720, 820, 1020, 1120) erste Flanken von dem ersten Pegel zu dem zweiten Pegel und zweite Flanken von dem zweiten Pegel zu dem ersten Pegel hat.

10. Phasendetektor nach Anspruch 9, wobei das Flip-Flop (430, 440, 930) das empfangene Datensignal (510, 610, 710, 1010, 1110) an der ersten Flanke des Takts speichert.

11. Phasendetektor nach Anspruch 10, wobei die ersten Flanken fallende Flanken und die zweiten Flanken steigende Flanken sind.

12. Phasendetektor nach Anspruch 7, wobei die Verzögerung durch das zweite Verzögerungselement (420, 920) so gesetzt wird, dass die Datenwiederherstellung von der ersten Speichervorrichtung durchgeführt wird.

13. Phasendetektor nach Anspruch 7, wobei die zweite Dauer variiert werden kann, um die Datenwiederherstellung durch den Phasendetektor (220) zu optimieren.

14. Phasendetektor nach Anspruch 7, wobei
das erste Verzögerungselement (410, 910) an einen Eingangsport gekoppelt ist;
das zweite Verzögerungselement (420, 920) an den Eingangsport gekoppelt ist;
die erste Speichervorrichtung (430, 930) aufweist:
wenigstens ein Flip-Flop (430, 440, 930) mit einem Eingang, der an einen Ausgang des zweiten Verzögerungselements (420, 920) gekoppelt ist, und
einem Takteingang (CKP, CKN), der an einen Taktport gekoppelt ist, und
wobei das wenigstens eine Flip-Flop (430, 440, 930) so konfiguriert ist, dass es das erste Datenwiederherstellungssignal und das zweite Datenwiederherstellungssignal basierend auf einer Verzögerung des zweiten Verzögerungselements (420, 920) ausgibt.

15. Phasendetektor nach Anspruch 14, wobei der Eingangsport so konfiguriert ist, dass er das empfangene Datensignal (510, 610, 710, 1010, 1110) empfängt, und wobei das empfangene Datensignal (510, 610, 701, 1010, 1110) ein differentielles Signal ist.

16. Phasendetektor nach Anspruch 14, wobei der Taktport so konfiguriert ist, dass er ein differentielles Taktsignal (520, 620, 720, 820, 1020, 1120) empfängt.

17. Phasendetektor nach Anspruch 14, wobei die erste Logikschaltung und die zweite Logikschaltung exklusive ODER-Gates (450, 460, 960, 970) sind.

18. Phasendetektor nach Anspruch 14, wobei die erste Logikschaltung ein Referenzsignal (580, 680, 780, 880, 1080) bereitstellt, und wobei die zweite Logikschaltung ein Fehlersignal (570, 670, 770, 870, 1070) bereitstellt.

19. Phasendetektor nach Anspruch 14, wobei der Phasendetektor (220) in einem optischen Sende-Empfangsgerät enthalten ist.

20. Optischer Empfänger nach Anspruch 19, wobei der optische Empfänger an den optischen Sender des optischen Sende-Empfangsgeräts gekoppelt ist.

21. Phasendetektor nach Anspruch 14, wobei der Phasendetektor (220) an einen Empfangsverstärker eines Systems zum Empfangen und Senden optischer Signale gekoppelt ist, wobei das System zum Empfangen und Senden optischer Signale aufweist:
eine Leuchtdiode (190), die so konfiguriert ist, dass sie optische Signale sendet;
einen Sender, der an die Leuchtdiode (190) gekoppelt ist;
eine Photodiode (110), die so konfiguriert ist, dass sie optische Signale empfängt; und
den Empfangsverstärker (120, 130), der an die Photodiode (110) gekoppelt ist.

22. Phasendetektor nach Anspruch 14, wobei die zweite Verzögerungsschaltung eine Verzögerung bereitstellt, die variabel ist.

23. Phasendetektor nach Anspruch 22, wobei die Verzögerung variiert werden kann, um die Datenwiederherstellung zu optimieren.

## Revendications

1. Procédé de récupération des données d'un signal de données (510, 610, 710, 1010, 1110) comprenant :
recevoir un signal d'horloge (520, 620, 720, 820, 1020, 1120) ayant une première fréquence d'horloge, et alterner entre un premier niveau et un deuxième niveau ;
recevoir le signal de données (510, 610, 710, 1010, 1110) ayant un premier débit, le premier débit étant sensiblement égal à la première fréquence d'horloge ;
fournir un premier signal (530, 630, 730, 830, 1030) en retardant le signal de données (510, 610, 710, 1010, 1110) d'une première durée ; **caractérisé par**
fournir un deuxième signal (540, 640, 740, 840, 1040) en retardant le signal de données (510, 610, 710, 1010, 1110) d'une deuxième durée, la deuxième durée étant une variable entre zéro et une valeur telle qu'un bord de transition du deuxième signal est proche d'un bord de transition du signal d'horloge ;
fournir un troisième signal (550, 650, 750, 850, 1050, 1150) en stockant le deuxième signal (540, 640, 740, 840, 1040) lorsque le signal d'horloge (520, 620, 720, 820, 1020, 1120) alterne du premier niveau au deuxième niveau ;
fournir un quatrième signal (560, 660, 760, 860, 1060, 1160) en stockant le troisième signal (550, 650, 750, 850, 1050, 1150) lorsque le signal d'horloge (520, 620, 720, 820, 1020, 1120) alterne du deuxième niveau au premier niveau ;
fournir un signal d'erreur (570, 670, 770, 870, 1070) en réalisant une fonction OU exclusif sur le premier signal (530, 630, 730, 830, 1030) et le troisième signal (550, 650, 750, 850, 1050, 1150) ; et
fournir un signal de référence (580, 680, 780, 880, 1080) en combinant le troisième signal (550, 650, 750, 850, 1050, 1150) et le quatrième signal (560, 660, 760, 860, 1060, 1160) .

2. Procédé selon la revendication 1 comprenant en outre :
appliquer le signal d'erreur (570, 670, 770, 870, 1070) et le signal de référence (580, 680, 780, 880, 1080) à un filtre à boucle (240) pour générer une sortie du filtre à boucle.

3. Procédé selon la revendication 1 dans lequel le quatrième signal (560, 660, 760, 860, 1060, 1160) comprend les données récupérées.

4. Procédé selon la revendication 3 dans lequel la fourniture du signal d'erreur (570, 670, 770, 870, 1070) et la fourniture du signal de référence (580, 680, 780, 880, 1080) sont effectuées par des portes OU exclusif (450, 460, 960, 970).

5. Procédé selon la revendication 3 dans lequel le premier retard est environ égal à un retard d'horloge à Q d'une bascule bistable (430, 440, 930) qui stocke le deuxième signal (540, 640, 740, 840, 1040).

6. Procédé selon la revendication 1 dans lequel la deuxième durée peut être modifiée pour optimiser la récupération des données.

7. Détecteur de phase servant à récupérer des données d'un signal de données (510, 610, 710, 1010, 1110) ayant un premier débit en utilisant un signal d'horloge (520, 620, 720, 820, 1020, 1120) ayant une première fréquence d'horloge et en alternant entre un premier niveau et un deuxième niveau, le premier débit étant sensiblement égal à la première fréquence d'horloge, comprenant :
un premier élément de retard (410, 910) configuré pour retarder le signal de données (510, 610, 710, 1010, 1110) d'une première durée ; **caractérisé par**
un deuxième élément de retard (420, 920) configuré pour retarder le signal de données (510, 610, 710, 1010, 1110) d'une deuxième durée, la deuxième durée étant une variable entre zéro et une valeur telle qu'un bord de transition du deuxième signal est proche d'un bord de transition du signal d'horloge ;
un premier dispositif de stockage (430, 930) configuré pour recevoir et stocker une sortie du deuxième élément de retard (420, 920) et fournir un premier signal de récupération de données et un deuxième signal de récupération de données ;
un deuxième dispositif de stockage (440, 940) configuré pour recevoir et stocker le deuxième signal de récupération de données et fournir un troisième signal de récupération de données lorsque le signal d'horloge alterne du deuxième niveau au premier niveau ;
un premier circuit logique (450, 960) configuré pour réaliser une fonction OU exclusif sur une sortie du premier élément de retard (410, 910) et du premier signal de récupération de données pour fournir un signal d'erreur (570, 670, 770, 870, 1070) ; et
un deuxième circuit logique (460, 970) configuré pour recevoir une sortie du premier dispositif de stockage (430, 930) et du deuxième dispositif de stockage (440, 940) et fournir un signal de référence (580, 680, 780, 880, 1080).

8. Détecteur de phase selon la revendication 7 dans lequel le premier dispositif de stockage comprend une bascule bistable (430, 440, 930).

9. Détecteur de phase selon la revendication 8 dans lequel la bascule bistable (430, 440, 930) reçoit le signal d'horloge (520, 620, 720, 820, 1020, 1120), le signal d'horloge (520, 620, 720, 820, 1020, 1120) ayant des premiers bords du premier niveau au deuxième niveau et des deuxièmes bords du deuxième niveau au premier niveau.

10. Détecteur de phase selon la revendication 9 dans lequel la bascule bistable (430, 440, 930) stocke le signal de données reçu (510, 610, 710, 1010, 1110) sur les premiers bords de l'horloge.

11. Détecteur de phase selon la revendication 10 dans lequel les premiers bords sont des bords descendants et les deuxièmes bords sont des bords montants.

12. Détecteur de phase selon la revendication 7 dans lequel un retard par le deuxième élément de retard (420, 920) est défini de telle sorte que la récupération des données soit effectuée par le premier dispositif de stockage.

13. Détecteur de phase selon la revendication 7 dans lequel la deuxième durée peut être modifiée pour optimiser la récupération des données par le détecteur de phase (220).

14. Détecteur de phase selon la revendication 7 dans lequel
ledit premier élément de retard (410, 910) est couplé à un port d'entrée ;
ledit deuxième élément de retard (420, 920) est couplé au port d'entrée ;
ledit premier dispositif de stockage (430, 930) comprend
au moins une bascule bistable (430, 440, 930) ayant une entrée couplée à une sortie du deuxième élément de retard (420, 920), et une entrée d'horloge (CKP, CKN) est couplée à un port de l'horloge, et ladite au moins une bascule bistable (430, 440, 930) est configurée pour sortir le premier signal de récupération de données et le deuxième signal de récupération de données sur la base d'un retard du deuxième élément de retard (420, 920).

15. Détecteur de phase selon la revendication 14 dans lequel le port d'entrée est configuré pour recevoir le signal de données reçu (510, 610, 710, 1010, 1110), et le signal de données reçu (510, 610, 710, 1010, 1110) est un signal différentiel.

16. Détecteur de phase selon la revendication 14 dans lequel le port de l'horloge est configuré pour recevoir un signal d'horloge différentiel (520, 620, 720, 820, 1020, 1120).

17. Détecteur de phase selon la revendication 14 dans lequel le premier circuit logique et le deuxième circuit logique sont des portes OU exclusif (450, 460, 960, 970).

18. Détecteur de phase selon la revendication 14 dans lequel le premier circuit logique fournit un signal de référence (580, 680, 780, 880, 1080), et le deuxième circuit logique fournit un signal d'erreur (570, 670, 770, 870, 1070).

19. Détecteur de phase selon la revendication 14, dans lequel le détecteur de phase (220) est compris dans un émetteur-récepteur optique.

20. Récepteur optique selon la revendication 19 dans lequel le récepteur optique est couplé à un émetteur optique de l'émetteur-récepteur optique.

21. Détecteur de phase selon la revendication 14, dans lequel le détecteur de phase (220) est couplé à un amplificateur de réception d'un système pour recevoir et transmettre des signaux optiques, le système pour recevoir et transmettre des signaux optiques comprenant :
une diode électroluminescente (190), configurée pour transmettre des signaux optiques ;
un émetteur couplé à la diode électroluminescente (190) ;
une photodiode (110), configurée pour recevoir les signaux optiques ; et
l'amplificateur de réception (120, 130) couplé à la photodiode (110).

22. Détecteur de phase selon la revendication 14 dans lequel le deuxième circuit à retard fournit un retard qui est variable.

23. Détecteur de phase selon la revendication 22 dans lequel le retard peut être modifié pour optimiser la récupération des données.
